# EUROPÄISCHE PATENTANMELDUNG

(11) **EP 2 933 258 A1**
(43) Veröffentlichungstag der Anmeldung: **21.10.2015**
(21) Anmeldenummer: 14192545.3
(22) Anmeldetag: 10.11.2014
(51) Int. Cl.: C07F 9/50, C07F 9/80, C07F 1/00, H01L 51/00, H01L 51/50

(54) **Heteroleptische Kupfer-Komplexe für optoelektronische Anwendungen**

(30) Priorität: 15.04.2014 EP 14164792
(71) Anmelder: cynora GmbH, 76646 Bruchsal (DE)
(72) Erfinder: Volz, Daniel, 76137 Karlsruhe (DE); Fléchon, Charlotte, 76646 Bruchsal (DE); Navarro, Dr. José Miguel, 67480 Roeschwoog (FR); Flügge, Dr.-Ing. Harald, 76135 Karlsruhe (DE)
(74) Vertreter: Hoppe, Georg Johannes

(57) **Zusammenfassung**

Die Erfindung betrifft Kupfer(I)komplexe der Formel 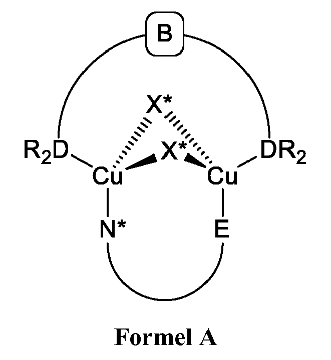 mit
X* = Cl, Br, I, CN, OCN, SCN, Alkinyl oder N₃,
N*∩E = unabhängig voneinander ein zweibindiger Ligand mit
E = Phosphanyl/Arsenyl/Antimonyl-Rest der Form R₂E (mit R = Alkyl, Aryl, Heteroaryl, Alkoxyl, Phenoxyl, oder Amid);
N* = Imin-Funktion, die Bestandteil einer aromatische Gruppe ist, die ausgewählt ist aus Pyridyl, Pyridazinyl, Pyrimidyl, Pyrazinyl, Triazinyl, Tetrazinyl, Oxazolyl, Thiazolyl, Imidazolyl, Pyrazolyl, Isoxazolyl, Isothiazolyl, 1,2,3-Triazolyl, 1,2,4-Triazolyl, 1,2,4-Oxadiazolyl, 1,2,4-Thiadiazolyl, Tetrazolyl, 1,2,3,4-Oxatriazolyl, 1,2,3,4-Thiatriazolyl, Chinolyl, Isochinolyl, Chinoxalyl, Chinazolyl,

"∩" = mindestens ein Kohlenstoffatom, das ebenfalls Bestandteil der aromatischen Gruppe ist, wobei sich das mindestens eine Kohlenstoffatom sowohl direkt benachbart zum Imin-Stickstoffatom als auch zum Phosphor-, Arsen- oder Antimonatom befindet,
R₂D-B-DR₂ = ein zweizähniger Liganden mit
D = unabhängig voneinander ausgewählt aus der Gruppe bestehend aus P, As und Sb, wobei D über eine Brücke B mit einem weiteren Rest D verbunden ist, der gleich oder verschieden zu D ist, wobei die Brücke B eine oder mehrere, gleiche oder verschiedene, substituierte oder unsubstituierte Alkylen-, Alkenylen-, Alkinylen- oder Arylen-Gruppe oder -O-, -NR- oder -SiR₂- ist oder eine Kombination dieser, wobei die Reste R jeweils unabhängig voneinander ausgewählt sind aus Wasserstoff, Deuterium Halogen oder Substituenten, die direkt oder über Sauerstoff- (-OR), Stickstoff- (-NR₂), Silizium- (-SiR₃) oder Schwefelatome (-SR) gebunden sind sowie Alkyl-, Heteroalkyl-, Aryl-, Heteroaryl-, Alkenyl-, Alkinyl-Gruppen oder substituierte Alkyl-, Heteroalkyl-, Aryl-, Heteroaryl- und Alkenyl-Gruppen, und weitere allgemein bekannte Donor- und Akzeptor-Gruppen.

## Beschreibung

Die Erfindung betrifft heteroleptische Kupfer(I)komplexe aufweisend eine Struktur der Formel A, insbesondere zur Verwendung in optoelektronischen Bauelementen.

### Einleitung

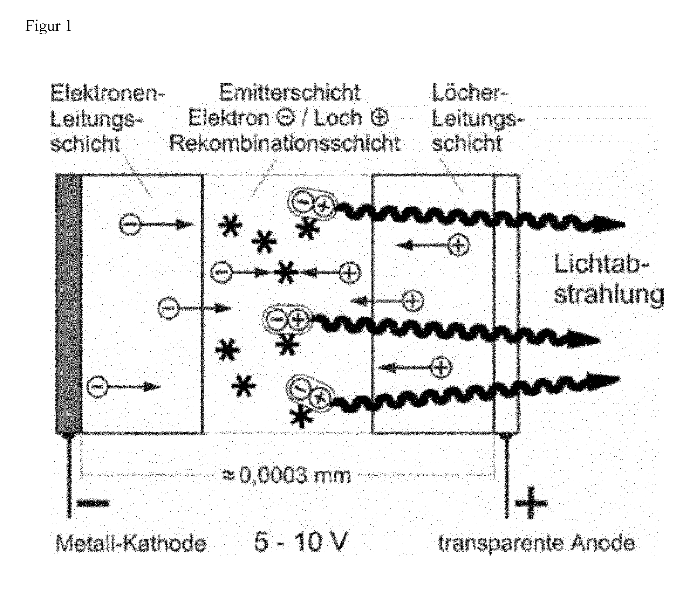

Zur Zeit zeichnet sich ein drastischer Wandel im Bereich der Bildschirm- und Beleuchtungstechnik ab. Es wird möglich sein, flache Displays oder Leuchtflächen mit einer Dicke von unter 0,5 mm zu fertigen. Diese sind durch viele faszinierende Eigenschaften ausgezeichnet. So werden z. B. Leuchtflächen als Tapeten mit sehr geringem Energieverbrauch realisierbar sein. Ferner werden Farbbildschirme mit bisher nicht erreichbarer Farb-Echtheit, Helligkeit und Blickwinkelunabhängigkeit, mit geringem Gewicht sowie sehr niedrigem Stromverbrauch herstellbar sein. Die Bildschirme werden sich als Mikro-Displays oder Großbildschirme mit mehreren m² Fläche in starrer Form oder flexibel, aber auch als Transmissions- oder Reflexions-Displays gestalten lassen. Ferner wird es möglich sein, einfache und kostensparende Herstellungsverfahren wie Siebdruck oder Tintenstrahldruck oder Vakuum-Sublimation einzusetzen. Dadurch wird im Vergleich zu herkömmlichen Flachbildschirmen eine sehr preiswerte Fertigung ermöglicht. Diese neue Technik basiert auf dem Prinzip der **OLEDs,** den **O**rganic **L**ight **E**mitting **D**iodes, die in Figur 1 schematisch und vereinfacht dargestellt ist.

Derartige Bauteile bestehen vorwiegend aus organischen Schichten, wie in Fig. 1 schematisch und vereinfacht gezeigt ist. Bei einer Spannung von z. B. 5 V bis 10 V treten aus einer leitenden Metallschicht, z. B. aus einer Aluminium-Kathode, negative Elektronen in eine dünne Elektronen-Leitungsschicht und wandern in Richtung der positiven Anode. Diese besteht z. B. aus einer durchsichtigen, aber elektrisch leitenden, dünnen Indium-Zinn-Oxid-Schicht, von der positive Ladungsträger, sog. Löcher, in eine organische Löcher-Leitungsschicht einwandern. Diese Löcher bewegen sich im Vergleich zu den Elektronen in entgegengesetzter Richtung, und zwar auf die negative Kathode zu. In einer mittleren Schicht, der Emitterschicht, die ebenfalls aus einem organischen Material besteht, befinden sich zusätzlich besondere Emitter-Moleküle, an denen oder in deren Nähe die beiden Ladungsträger rekombinieren und dabei zu neutralen, aber energetisch angeregten Zuständen der Emitter-Moleküle führen. Die angeregten Zustände geben dann ihre Energie als helle Lichtemission ab, z. B. in blauer, grüner oder roter Farbe. Auch Weiß-LichtEmission ist realisierbar. Auf die Emitterschicht kann gegebenenfalls auch verzichtet werden, wenn die Emittermoleküle sich in der Loch- oder Elektronen-Leitungsschicht befinden.

Die neuen OLED-Bauelemente lassen sich großflächig als Beleuchtungskörper oder auch äußerst klein als Pixel für Displays gestalten. Entscheidend für den Bau hoch-effektiver OLEDs sind die verwendeten Leuchtmaterialien (Emitter-Moleküle). Diese können in verschiedener Weise realisiert werden, und zwar unter Verwendung rein organischer oder metall-organischer Moleküle sowie von Komplexverbindungen. Es lässt sich zeigen, dass die Lichtausbeute der OLEDs mit metallorganischen Substanzen, den sog. Triplett-Emittern, wesentlich größer sein kann als für rein organische Materialien. Aufgrund dieser Eigenschaft kommt der Weiterentwicklung der metallorganischen Materialien ein wesentlicher Stellenwert zu. Die Funktion von OLEDs ist bereits sehr häufig beschrieben worden (C. Adachi, M. A. Baldo, S. R. Forrest, S. Lamansky, M. E. Thompson, R. C. Kwong, Appl. Phys. Lett. 2001, 78, 1622; X. H. Yang, D. C. Müller, D. Neher, K. Meerholz, Adv. Mater. 2006, 18, 948; X. H. Yang, D. Neher, Appl. Phys. Lett. 2004, 84, 2476; J. Shinar (Hrsg.), Organic light-emitting devices - A survey, AIP-Press, Springer, New York, 2004; H. Yersin, Top. Curr. Chem. 2004, 241, 1; H. Yersin, Highly Efficient OLEDs with Phosphorescent Materials, Wiley-VCH, Weinheim 2008; Z. H. Kafafi, Organic Electroluminescence, Taylor & Francis, Boca Raton, 2005). Unter Einsatz von metallorganischen Komplexen mit hoher Emissionsquantenausbeute (Übergänge unter Einbeziehung der untersten Triplett-Zustände zu den Singulett-Grundzuständen) lässt sich eine besonders hohe Effizienz des Devices erzielen. Diese Materialien werden häufig als Triplett-Emitter oder phosphoreszierende Emitter bezeichnet. Diese Erkenntnis ist seit längerem bekannt (C. Adachi, M. A. Baldo, S. R. Forrest, S. Lamansky, M. E. Thompson, R. C. Kwong, Appl. Phys. Lett. 2001, 78, 1622; X. H. Yang, D. C. Müller, D. Neher, K. Meerholz, Adv. Mater. 2006, 18, 948; X. H. Yang, D. Neher, Appl. Phys. Lett. 2004, 84, 2476; J. Shinar (Hrsg.), Organic light-emitting devices - A survey, AIP-Press, Springer, New York, 2004; H. Yersin, Top. Curr. Chem. 2004, 241, 1; H. Yersin, Highly Efficient OLEDs with Phosphorescent Materials, Wiley-VCH, Weinheim 2008).

Kupferkomplexe der Form Cu₂X₂L₄, Cu₂X₂L'₂ und Cu₂X₂L₂L' (L = Phosphan-, Amin-, Imin-Ligand; L' = zweizähniger Phosphan-, Imin-, Amin-Ligand, s.u.) sind bereits aus dem Stand der Technik bekannt. Sie zeigen intensive Lumineszenz bei Anregung mit UV Licht. Die Lumineszenz kann entweder von einem MLCT-, CC (*cluster centered*)- oder XLCT (*halogen*-*to*-*ligand*-*charge-transfer*)*-Zustand* oder einer Kombination dieser stammen. Weitere Einzelheiten zu ähnlichen Cu(I)-Systemen können der Literatur entnommen werden (P. C. Ford, E. Cariati, J. Bourassa, Chem. Rev. 1999, 99, 3625). Bei dem verwandten [Cu₂X₂(PPh₃)₂nap]-Komplex (nap = 1,8-Naphthyridin, X = Br, I) wird ein Übergang zwischen dem Molekülorbital der {Cu₂X₂}-Einheit (Cu d und Halogen p-Orbitale) und den p*-Orbitalen der nap-Gruppe diskutiert (H. Araki, K. Tsuge, Y. Sasaki, S. Ishizaka, N. Kitamura, Inorg. Chem. 2007, 46, 10032).

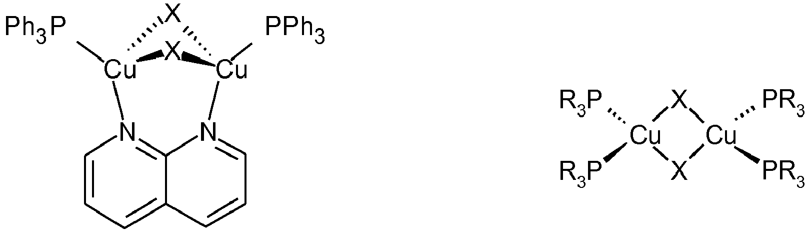

Beispiel einer Struktur der Komplexe der Form Beispiele der Komplexe der Form Cu₂X₂L₄ (L = Cu₂X₂L₂L' (L = PPh₃, L' = 1,8-Naphthyridin, X PR₃, X = Cl, Br, oder I) = Br, I)

Triplett-Emitter weisen ein großes Potential zur Lichterzeugung in Displays (als Pixel) und in Beleuchtungsflächen (z. B. als Leuchttapete) auf. Sehr viele Triplett-Emitter-Materialien wurden bereits patentiert und werden mittlerweile auch technologisch in ersten Devices eingesetzt. Die bisherigen Lösungen weisen Nachteile und Probleme auf, und zwar in folgenden Bereichen:
- Langzeitstabilität der Emitter in den OLED-Devices,
- Thermische Stabilität,
- Chemische Stabilität gegenüber Wasser und Sauerstoff,
- Verfügbarkeit wichtiger Emissionsfarben,
- Fertigungstechnische Reproduzierbarkeit,
- Erreichbarkeit einer hohen Effizienz bei hohen Stromdichten,
- Erreichbarkeit sehr hoher Leuchtdichten,
- Hoher Preis der Emittermaterialien,
- Emittermaterialien sind toxisch und
- Synthesen sind aufwendig.

Vor diesem Hintergrund sollten mit der vorliegenden zumindest einige der oben genannten Nachteile überwunden werden.

### Beschreibung der Erfindung

Das der Erfindung zu Grunde liegende Problem wird durch die Bereitstellung von heteroleptischen zweikernigen Kupfer(I)komplexen der Form Cu₂X₂(E∩N*)R₂D-B-DR₂ gelöst, die eine Struktur gemäß Formel A aufweisen oder von einer Struktur nach Formel A sind:

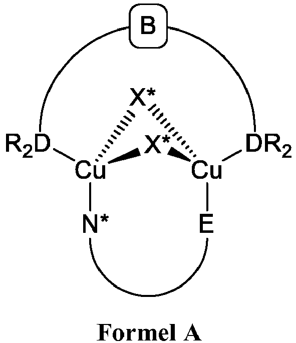

In Formel A (nachfolgend auch als Cu₂X*₂(E∩N*)R₂D-B-DR₂ bezeichnet) steht E∩N* für einen chelatisierenden N-heterozyklischen Liganden, der über ein Stickstoffatom und entweder ein Phosphor-, Arsen- oder Antimonatom an den Cu₂X₂-Kern bindet, und R₂D-B-DR₂ für einen zweizähnigen Liganden, wobei D unabhängig voneinander gewählt ist aus der Gruppe bestehend aus P, As und Sb und wobei der Ligand R₂D-B-DR₂ auch mit E∩N* einfach oder zweifach verbunden sein kann, so dass sich ein offener (=offenkettiger) oder geschlossener (=zyklischer) vierzähniger Ligand ergibt. X* steht unabhängig voneinander für Cl, Br, I, CN, OCN, SCN, Alkinyl und/oder N₃.

Der Vorteil bei Verwendung von zwei- oder mehrzähnigen Liganden liegt in der erhöhten chemischen, photophysikalischen und thermischen Stabilität, die auf dem Chelateffekt der Liganden beruhen. Dieser "Chelat-Effekt" hat zwei Ursachen. Zum einen ist die Entropieabnahme bei der Komplexbildung geringer, was einen thermodynamischen Stabilisierungseffekt hat. In Formel A bildet sich aus zwei organischen Liganden ein Komplex. Im Falle von einzähnigen, also nichtchelatisierenden Liganden würden sich vier Liganden zu einem Komplex verbinden. Zum anderen kann ein Chelatligand sich erst nach Auflösung aller Bindungen vom Zentralatom entfernen, was bedeutet, dass der Chelator viel schlechter vom Metallion dissoziieren kann. Damit sind Chelatkomplexe stabiler als Komplexe mit einzähnigem Liganden. Damit steigt ebenfalls die Wahrscheinlichkeit der sofortigen Rekombination nach der Spaltung.

Bei Verwendung von überbrückten Bisphosphinen, Bisarsinen und Bisantimonaten als Liganden ergibt sich ein weiterer Parameter, nämlich die Kettenlänge des Liganden. Um die Ausbildung der gewünschten *butterfly*-Struktur zu ermöglichen, müssen die verwendeten Phosphine eine ausreichende Kettenlänge sowie eine ausreichende Flexibilität aufweisen.

In Formel A wirken ab einem Abstand von 4 Einheiten (= Spacerlänge) zwischen den beiden Donoratomen D diese als verbrückende Liganden, da dann aufgrund sterischer Wechselwirkung eine Koordination beider Donoratome D an einem Metallzentrum nachteilig wird. Bevorzugt ist eine Spacerlänge von größer 4. Durch die dominierende Cu₂X*₂(E∩N*)-Einheit werden Bisphosphine begünstigt, die einen engen Bisswinkel bei gleichzeitig großem Abstand der Donoratome aufweisen. Bereits durch MM2-Berechnungen auf niedrigem Niveau lässt sich qualitativ erkennen, dass dies für dppb (Spacerlänge 4) nur unter großer Verzerrung möglich ist. Tatsächlich findet man bei einer Komplexierungsreaktion mit einem CuX*:PyrPHOS:dppx-Verhältnis von 2:1:1 erst ab x = 5 die Bildung des gewünschten Produktes.

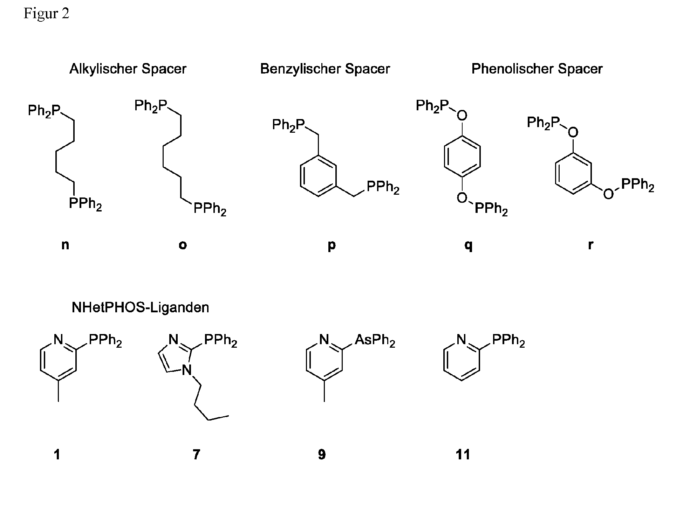

In Figur 2 sind beispielhaft verwendete überbrückende Liganden R₂D-B-DR₂ sowie beispielhaft verwendete E∩N* -Liganden aufgeführt. Als Beispiele sind unten entsprechende Verbindungen sowie einige physikalische Eigenschaften aufgeführt.

In Tabelle 1 sind photophysikalische Daten und Zersetzungstemperaturen aufgeführt. Die Emissionswellenlänge der Pulverproben ist im für unverbrückte Cu₂X*₂(E∩N*)₃- bzw. Cu₂X*₂(E∩N*)L₂-Komplexe erwarteten Bereich um 540 nm. Die thermische Stabilität der Verbindungen mit den beispielhaften Brückenliganden **n** und **o** war durchgehend höher als bei den vergleichbaren unverbrückten Verbindungen **(1-I-n** bis **1-I-p:** ca. 295 °C, vgl Komplex **1-I-1:** 260 °C). Hierbei steht **1** für den entsprechenden E∩N*-Liganden, **I** für Cu₂I₂, und **n** bis **r** für den überbrückende Liganden R₂D-B-DR₂.

**Tabelle 1: Beispielhafte überbrückte, zweikernige NHetPHOS-Komplexe**

| | **λₑₘ [nm]** | **PLQY Φ** | **Löslichkeit (qualitativ)** | **T_{dec} [°C]** |
|---|---|---|---|---|
| **1**-**I**-**n** | 551 | 0.63 | gut | 310 |
| **1-I-o** | 552 | 0.51 | mäßig | 290 |
| **1**-**I**-**p** | 540 | 0.26 | schlecht | 297 |
| **1**-**I**-**q** | 545 | 0.13 | gut | 205 |
| **1**-**I**-**r** | 520 | 0.10 | gut | 225 |
| **7-I-o** | 525 | 0.46 | gut | - |
| **9**-**I**-**q** | 540 | 0.05 | gut | 207 |
| **11-I-o** | 550 | 0.61 | schlecht | 250 |

Φ +/- 5%; Emissionsmaximum +/- 1 nm. Löslichkeit bezogen auf Dichlormethan. Pulverdaten, Raumtemperatur Anregung 350 nm. -. = Wert nicht bestimmt.

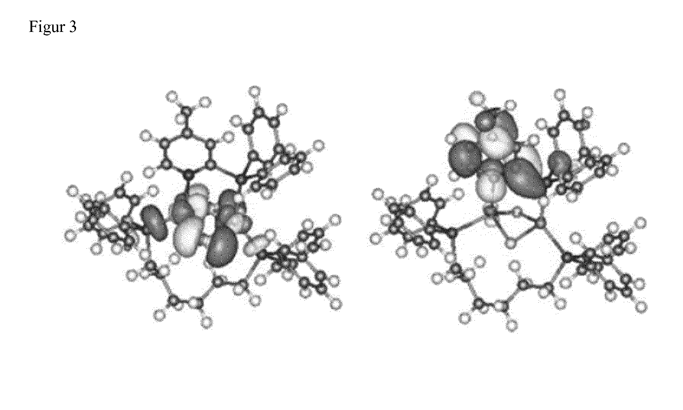

Die Ergebnisse von DFT- und TDDFT-Rechnungen sind in Figur 3 und Tabelle 2 aufgeführt. Demnach findet sich bei Betrachtung der Grenzorbitale eine ähnliche Situation wie bei den unverbrückten Komplexen.
Tabelle 2 zeigt einen Vergleich von experimentell bestimmten Energien und den Ergebnissen der DFT- und TDDFT-Rechnungen. Die HOMO-Energie lässt sich demnach hinreichend genau beschreiben (Differenz: 0,2 eV), wohingegen für die Triplett-Energie ΔE(S₀-T₁) Experiment und Theorie sehr gut übereinstimmen (Differenz max. 0,05 eV).

**Tabelle 2: Vergleich experimenteller Werte und theoretisch berechneter Werte für Komplex 1-I-n und 1-I-o.**

| | **E_{HOMO,PESA} [eV]** | **E_{HOMO,DFT} [eV]** | **ΔE(S₀-T₁)^{a} [eV]** | **AE(S₀- T₁)_{TDDFT}^{b} [eV]** |
|---|---|---|---|---|
| **1**-**I**-**n** | 5.35 | 5.56 | 2.54 | 2.54 |
| **1**-**I**-**o** | 5.36 | 5.55 | 2.59 | 2.55 |

Messgenauigkeit PESA +/- 0.10 eV. ^{a} = Messung der Triplettenergie durch Fitten des Onsets der Emission bei 77 K, +/- 0.05 eV 5%. ^{b} = Berechnung durch Verwendung von CAM-B3LYP. PESA = photoelectron spectroscopy in air (Photoelektron Spektroskopie in Luft)

Zusammengefasst stellt die Verwendung von überbrückenden Liganden eine gute Möglichkeit dar, um die Stabilität der NHetPHOS-Komplexe zu erhöhen, ohne die photophysikalischen Eigenschaften des Stammsystems nennenswert zu beeinflussen.

Ein erfindungsgemäßer Kupfer(I)komplex besteht bevorzugt aus einem zweibindigen Liganden N*∩E und einem zweizähnigen Liganden R₂D-B-DR₂, wodurch unterschiedliche Funktionalitäten über die Peripherie der verschiedenen Liganden eingeführt werden können (beispielsweise je eine Lochtransport- und Elektrontransport-Einheit, im Folgenden als Loch- bzw. Elektronenleiter bezeichnet) und somit ein optimaler Ladungsträgertransport zu und eine wohldefinierte Rekombination direkt auf dem Kupferkomplex gewährleistet wird. Der große Vorteil bei der Verwendung von Kupfer als Zentralmetall ist dessen niedriger Preis, v. a. im Vergleich zu den sonst bei OLED-Emittern üblichen Metallen wie Re, Os, Ir und Pt. Zusätzlich spricht auch die geringe Toxizität des Kupfers für dessen Verwendung.

Hinsichtlich ihrer Verwendung in optoelektronischen Bauelementen zeichnen sich die erfindungsgemäßen Kupfer(I)komplexe durch einen weiten Bereich von erzielbaren Emissionsfarben aus. Zudem ist die Emissionsquantenausbeute hoch, insbesondere größer als 50 %. Für Emitterkomplexe mit Cu-Zentralion, sind die Emissionsabklingzeiten erstaunlich kurz.

Außerdem sind die erfindungsgemäßen Kupfer(I)komplexe in relativ hohen Emitterkonzentrationen ohne deutliche Quencheffekte verwendbar. Das heißt, im Emitter-Layer können Emitterkonzentrationen von 5 % bis 100 % verwendet werden.

Bevorzugt handelt es sich bei dem Liganden N*∩E um folgende Liganden: 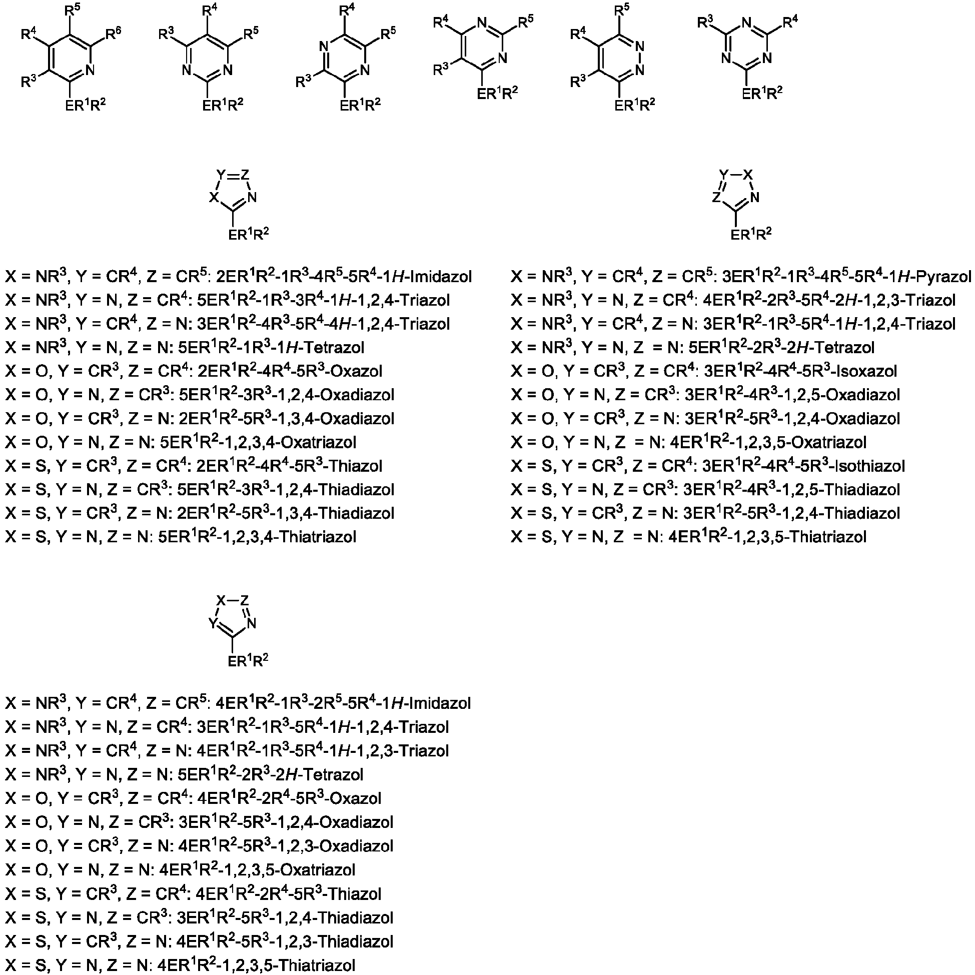 mit
E = unabhängig voneinander ausgewählt aus der Gruppe bestehend aus P, As und Sb,
X = unabhängig voneinander ausgewählt aus der Gruppe bestehend aus NR³, O und S,
Y = unabhängig voneinander ausgewählt aus der Gruppe bestehend aus CR³, CR⁴ und N,
Z = unabhängig voneinander ausgewählt aus der Gruppe bestehend aus CR⁴, CR⁵ und N,
R¹-R⁶ = unabhängig voneinander ausgewählt aus der Gruppe bestehend aus Wasserstoff, Halogen, Deuterium und Substituenten, die direkt oder über Sauerstoff- (-OR), Stickstoff- (-NR₂), Silizium-(-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anelliert sind. R³-R⁶ können optional auch zu anellierten Ringsystemen führen.

Bevorzugt handelt es sich bei dem Liganden R₂D-B-DR₂ um einen zweizähnigen Liganden mit D = unabhängig voneinander ausgewählt aus der Gruppe bestehend aus P, As und Sb, R₂ = unabhängig voneinander ausgewählt aus der Gruppe bestehend aus Wasserstoff, Halogen, Deuterium und Substituenten, die direkt oder über Sauerstoff- (-OR), Stickstoff- (-NR₂), Silizium-(-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, die optional weiter substituiert und/oder anelliert sind. D ist über eine Brücke B mit einem weiteren, gleichen oder verschiedenen Rest D verbunden ist und damit einen zweizähnigen Liganden bildet, wobei die Brücke B eine oder mehrere, gleiche oder verschiedene, substituierte oder unsubstituierte Alkylen-, Alkenylen-, Alkinylen- oder Arylen-Gruppe oder -O-, -NR- oder -SiR₂- ist oder eine Kombination dieser, wobei jedes R unabhängig voneinander ausgewählt ist aus der Gruppe bestehend aus Wasserstoff, Halogen, Deuterium und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen. Die zwei einzelnen Reste R können auch zu anellierten Ringsystemen führen.

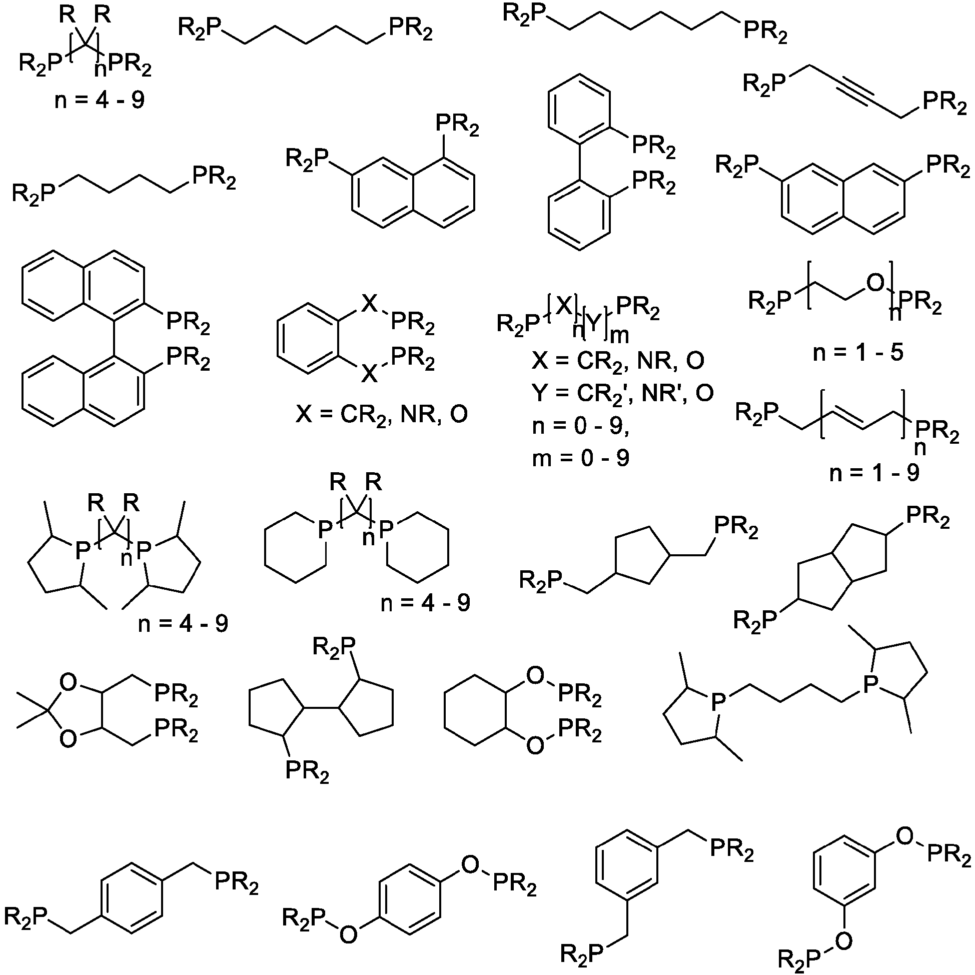

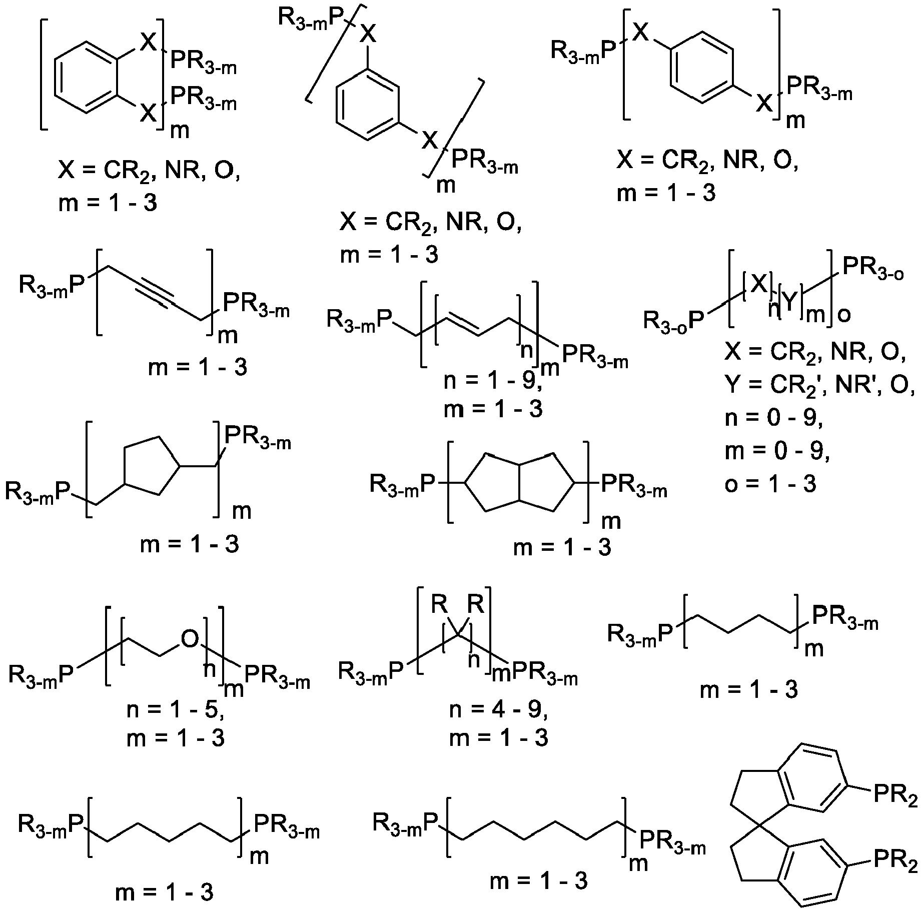

Sowohl der zweibindige Ligand N*∩E als auch der zweizähnige Ligand R₂D-B-DR₂ können an geeigneten Stellen mit mindestens einer Funktions-Gruppe FG substituiert sein. So können sich direkte C_{FG}-C_{N*∩E} Bindungen bilden, wobei C_{N*∩E} ein C-Atom des N*∩E Liganden darstellt und C_{FG} ein C-Atom der Funktions-Gruppe. Ist das anbindende Atom ein Stickstoffatom, so ergeben sich N_{FG}-C_{N*∩E} Bindungen, wobei N_{FG} für das Stickstoffatom steht. Andererseits kann die Funktions-Gruppe über eine Brücke an den N*∩E Liganden angeknüpft werden, wobei sich z. B. Ether-, Thioether-, Ester-, Amid-, Methylen-, Silan-, Ethylen-, Ethin-Brücken anbieten. Damit können sich als Brücken beispielsweise folgende Funktionen ergeben: C_{FG}-O-C_{N*∩E}, C_{FG}-S-C_{N*∩E}, C_{FG}-C(O)-O-C_{N*∩E}, C_{FG}-C(O)-NH-C_{N*∩E}, C_{FG}-CH₂-C_{N*∩E}, C_{FG}-SiR'₂-C_{N*∩E}, C_{FG}-CH=CH-C_{N*∩E}, C_{FG}-C≡C-C_{N*∩E}, N_{FG}-CH₂-C_{N*∩E}.

Die Verfahren zur Verknüpfung der Funktionsgruppe an den N*∩E Ligand und/oder an den Ligand R₂D-B-DR₂, entweder direkt oder über eine Brücke, sind dem Fachmann bekannt (Suzuki-, Still-, Heck-, Sonogashira-, Kumada-, Ullmann-, Buchwald-Hartwig-Kupplung sowie deren Varianten; (Thio)Veretherung, Veresterung, nucleophile und elektrophile Substitutionen am sp³-Kohlenstoff oder Aromaten, usw.). Beispielsweise illustriert der in der Literatur beschriebene Ligand (4,4'-Bis(5-(hexylthio)-2,2'-bithien-5'-yl)-2,2'-bipyridine) die Möglichkeit einer Anbindung eines elektronenleitenden Substituenten an einen bpy Liganden mittels einer Stille Kupplung (C.-Y. Chen, M. Wang, J.-Y. Li, N. Pootrakulchote, L. Alibabaei, C.-h. Ngoc-le, J.-D. Decoppet, J.-H. Tsai, C. Grätzel, C.-G. Wu, S. M. Zakeeruddin, M. Grätzel, ACS Nano 2009, 3, 3103).

In einer besonderen Ausführungsform kann der Rest R des N*∩E-Liganden und/oder des Liganden R₂D-B-DR₂ auch ein elektronenleitender, lochleitender oder die Löslichkeit erhöhender Substituent sein.

Die Erfindung betrifft auch ein Verfahren zur Herstellung eines erfindungsgemäßen Kupfer(I)komplexes. Dieses erfindungsgemäße Verfahren weist den Schritt des Durchführens einer Reaktion von N*∩E und R₂D-B-DR₂ mit Cu(I)X* auf,
wobei
X* = Cl, Br, I, CN, OCN, SCN, Alkinyl und/oder N₃ (unabhängig voneinander),
N*∩E = ein zweibindiger Ligand mit
E = Phosphanyl/Arsenyl/Antimonyl-Rest der Form R₂E (mit R = Alkyl, Aryl, Heteroaryl, Alkoxyl, Phenoxyl, oder Amid);
N* = Imin-Funktion, die Bestandteil einer aromatische Gruppe ist, die ausgewählt ist aus Pyridyl, Pyridazinyl, Pyrimidyl, Pyrazinyl, Triazinyl, Tetrazinyl, Oxazolyl, Thiazolyl, Imidazolyl, Pyrazolyl, Isoxazolyl, Isothiazolyl, 1,2,3-Triazolyl, 1,2,4-Triazolyl, 1,2,4-Oxadiazolyl, 1,2,4-Thiadiazolyl, Tetrazolyl, 1,2,3,4-Oxatriazolyl, 1,2,3,4-Thiatriazolyl, Chinolyl, Isochinolyl, Chinoxalyl, Chinazolyl, etc., die optional weiter substituiert und/oder anneliert sind,
"∩" = mindestens ein Kohlenstoffatom, das ebenfalls Bestandteil der aromatischen Gruppe ist, wobei sich das mindestens eine Kohlenstoffatom sowohl direkt benachbart zum Imin-Stickstoffatom als auch zum Phosphor-, Arsen- oder Antimonatom befindet,
und ein zweizähniger Ligand R₂D-B-DR₂ mit
D = Phosphanyl/Arsenyl/Antimonyl-Rest der Form R₂D, der über eine Brücke B mit einem weiteren, gleichen oder verschiedenen Rest D verbunden ist, wobei die Brücke B eine oder mehrere, gleiche oder verschiedene, substituierte oder unsubstituierte Alkylen-, Alkenylen-, Alkinylen- oder Arylen-Gruppe oder -O-, -NR- oder -SiR₂- ist oder eine Kombination dieser, wobei die Reste R unabhängig voneinander ausgewählt sind aus der Gruppe bestehend aus Wasserstoff, Halogen, Deuterium und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl-(auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen. Die Reste R können auch zu anellierten Ringsystemen führen.

Der optional am Liganden N*∩E und/oder R₂D-B-DR₂ vorhandene mindestens eine Substituent zur Erhöhung der Löslichkeit des Komplexes in organischen Lösungsmitteln und/oder zur Verbesserung des Ladungsträgertransports ist weiter unten beschrieben.

Die Reaktion wird bevorzugter Weise in Dichlormethan (DCM) durchgeführt, wobei auch andere organische Lösungsmittel wie Acetonitril oder Tetrahydrofuran oder Dimethylsulfoxid oder Ethanol verwendet werden können. Durch die Zugabe von Diethylether oder Hexan oder Methyl-tert-butylether oder Pentan oder Methanol oder Ethanol oder Wasser zum gelösten Produkt kann ein Feststoff gewonnen werden. Letzteres kann durch Fällung oder Eindiffusion oder in einem Ultraschall-Bad durchgeführt werden.

Bei der Reaktion von zweizähnigen P∩N*-Liganden (P∩N* = Phosphan-Ligand, Definition s. u.) und R₂D-B-DR₂ mit Cu(I)X* (X* = Cl, Br, I), bevorzugt in Dichlormethan (DCM), bevorzugt bei Raumtemperatur, entsteht überraschend der zweikernige 2:3-Komplex Cu₂X*₂(E∩N*)R₂D-B-DR₂, in dem die Cu-Atome durch einen P∩N*-Ligand, einen R₂D-B-DR₂-Ligand sowie die beiden Halogenid-Anionen überbrückt werden (Gl. 1).

Die Struktur der Formel A ist verwandt mit bekannten Komplexen der Form Cu₂X₂L₂L' bzw. Cu₂X₂L₄. Anders als bei Cu₂X₂L₂L' ist der Komplex jedoch in nur einem Schritt durch Umsetzung von Cu(I)X* mit dem zweizähnigen P∩N* Liganden und einem zweizähnigen Liganden R₂D-B-DR₂ zugänglich. Der Komplex kann durch Fällen mit Et₂O als gelbes oder rotes mikrokristallines Pulver isoliert werden. Einkristalle können durch langsames Eindiffundieren von Et₂O in die Reaktionslösung erhalten werden. Sobald die Komplexe als Pulver oder Kristalle vorliegen, sind sie in gängigen organischen Lösungsmitteln teilweise schwer löslich bis unlöslich. Insbesondere bei niedrigen Löslichkeiten wurden Komplexe nur durch Elementar- und Röntgenstrukturanalysen identifiziert.

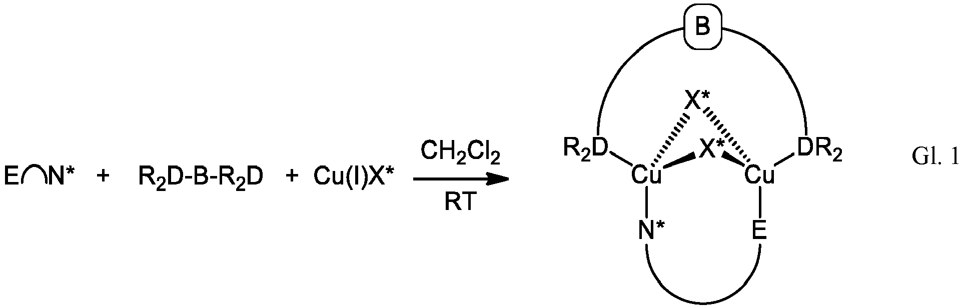

Hierbei handelt es sich um die oben aufgeführte allgemeine Formel A. Die zweizähnigen E∩N*-Liganden und/oder der zweizähnige Ligand R₂D-B-DR₂ können unabhängig voneinander mindestens einen Substituenten umfassen: Die Substituenten können jeweils unabhängig voneinander ausgewählt sein aus der Gruppe bestehend aus Wasserstoff, Halogen, Deuterium und Substituenten, die direkt oder über Sauerstoff- (-OR), Stickstoff- (-NR₂), Silizium- (-SiR₃) oder Schwefelatome (-SR) gebunden sind sowie Alkyl- (auch verzweigt oder zyklisch), Heteroalkyl-, Aryl-, Heteroaryl-, Alkenyl-, Alkinyl-Gruppen bzw. substituierte Alkyl- (auch verzweigt oder zyklisch), Heteroalkyl-, Aryl-, Heteroaryl- und Alkenyl-Gruppen (mit Substituenten wie Halogene oder Deuterium, Alkylgruppen (auch verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen. Die Substituenten können auch zu anellierten Ringsystemen führen.

### Substituenten zur Einführung unterschiedlicher Funktionalitäten

Die oben genannten Substituenten zur Einführung unterschiedlicher Funktionalitäten über die verschiedenen Liganden (beispielsweise Loch- und/oder Elektronenleiter) zur Gewährleistung eines guten Ladungsträgertransports und einer wohldefinierten Rekombination direkt auf dem Kupferkomplex, können entweder einfach oder mehrfach am E∩N*- und/oder R₂D-B-DR₂-Liganden gebunden sein. Es können identische oder unterschiedliche Funktions-Gruppen verwendet werden. Die Funktions-Gruppen können symmetrisch oder unsymmetrisch vorhanden sein.

### Elektronenleiter

Da es sich bei den Elektronenleiter-Materialien ausschließlich um aromatische Verbindungen handelt, ist eine Substitution mithilfe einer der gängigen Kupplungsreaktionen möglich. Als Kupplungsreaktionen kommen z. B. die Suzuki-, Still-, Heck-, Sonogashira-, Kumada-, Ullmann-, Buchwald-Hartwig-Kupplung sowie deren Varianten zu Einsatz.

Dabei geht man von einem mit Halogenid (Cl, Br, I), insbesondere Br, substituierten E∩N*-und/oder R₂D-B-DR₂-Liganden aus und setzt diesen mit dem entsprechenden, mit einer geeigneten Abgangsgruppe substituierten Elektronenleiter-Material um. Vorteilhaft ist die Durchführung einer Suzuki-Kupplung unter Verwendung der entsprechenden Arylboronsäuren und -estern, sowie die Buchwald-Hartwig-Kupplung für die Knüpfung von Aryl-N-Bindungen. Abhängig von den Funktions-Gruppen können auch weitere, gängige Verknüpfungsreaktionen angewandt werden, z. B. über eine Brücke zwischen Funktions-Gruppe FG und E∩N*- und/oder R₂D-B-DR₂-Ligand. Bei Anwesenheit von -OH Gruppen kommen hier z. B. Veresterungen und Etherbildung in Frage, bei-NH₂ Gruppen Imin- und Amidbildung, bei -COOH Gruppen Esterbildung. Entsprechend muss das Subsitutionsmuster des E∩N*- und/oder R₂D-B-DR₂-Ligand angepasst werden. Die entsprechenden Verfahren zur Anbringung der Funktions-Gruppen FG sind dem Fachmann bekannt.

Als Elektronentransport-Substituenten können beispielsweise folgende Gruppen verwendet werden (Verknüpfung findet an der mit # gekennzeichneten Stelle statt):

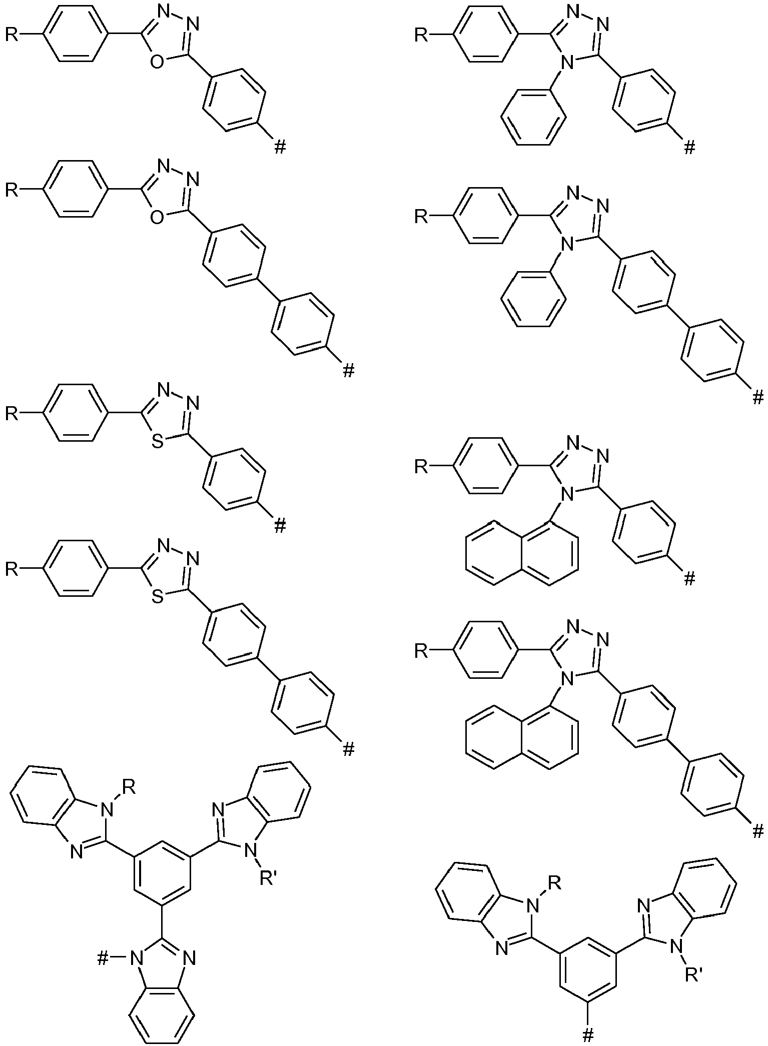

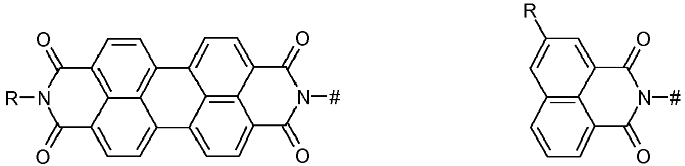

Bei den Substituenten R und R' handelt es sich um einen Alkyl-Rest [CH₃-(CH₂)ₙ-] (n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR"'₃) oder Ethergruppen -OR"' (R"' definiert wie R; die hier verwendeten Substituenten entsprechen nicht notwendiger Weise den Substituenten R der Formel A) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Silan- (-SiR"₃) oder Ethergruppen -OR" (R" definiert wie R) substituiert sein können.

### Lochleiter

Für den Lochleiter gelten analog die gleichen Aussagen wie für die Elektronenleiter. Auch hier wird die Verknüpfung des Lochleiters an den E∩N*- und/oder R₂D-B-DR₂-Liganden am einfachsten durch Palladium-katalysierte Kupplungsreaktionen verwirklicht; weitere Verknüpfungen, auch über eine Brücke, sind ebenfalls möglich.

Als Lochtransport-Substituenten können beispielsweise folgende Gruppen verwendet werden (Verknüpfung findet an der mit # gekennzeichneten Stelle statt):

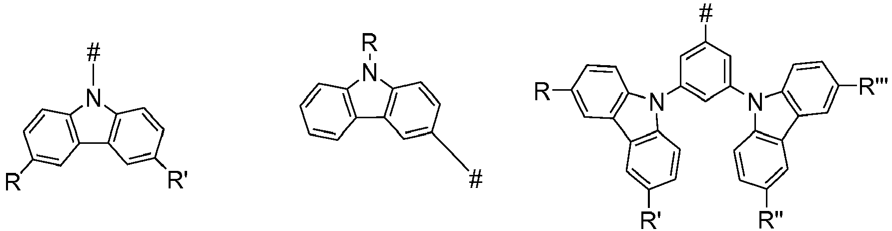

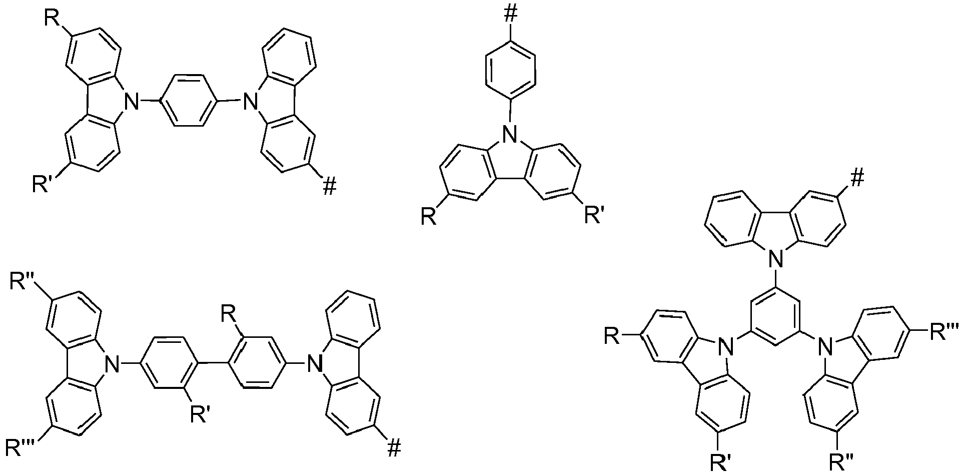

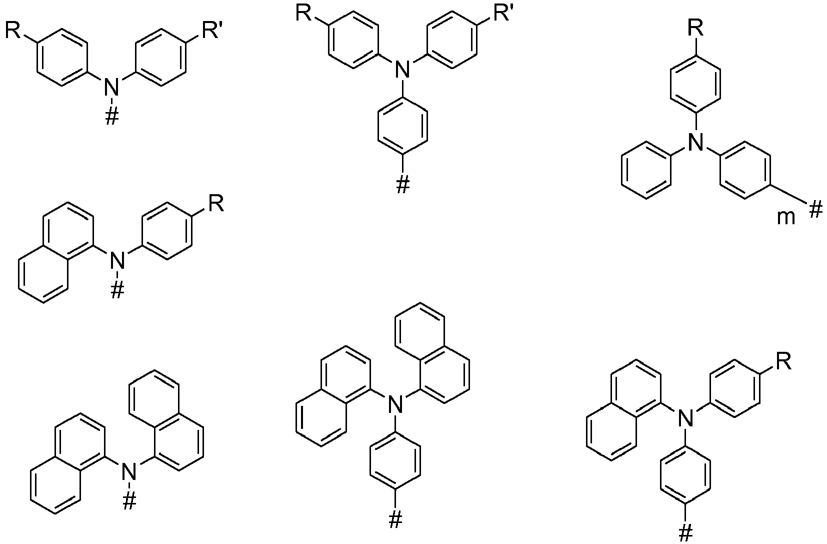

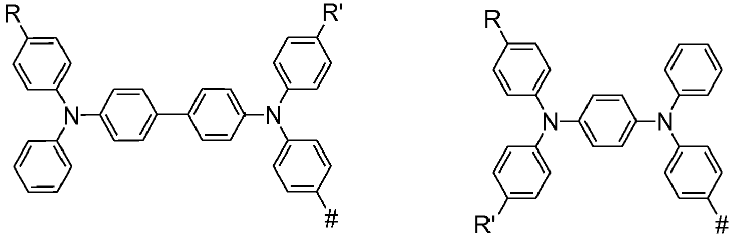

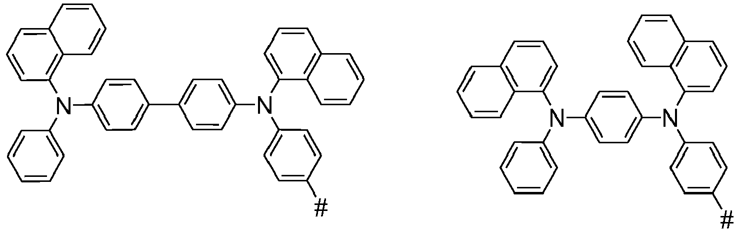

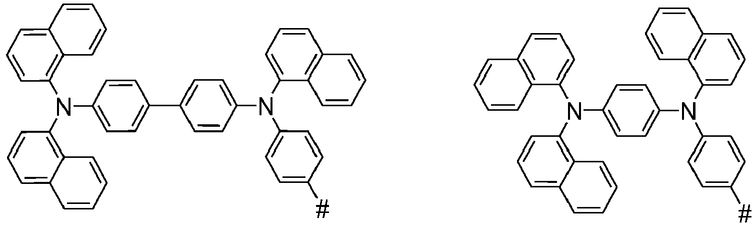

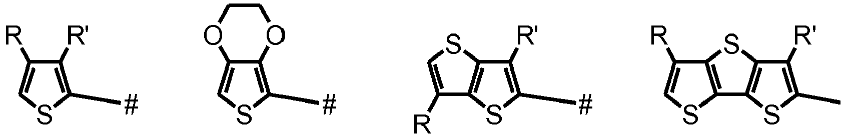

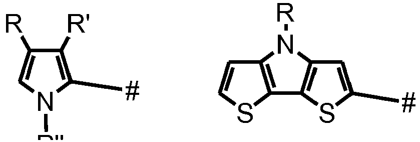

Bei den oben gezeigten Substituenten R, R" und R'" handelt es sich um einen Alkyl-Rest [CH₃-(CH₂)ₙ-] (n = 0 - 20), der auch verzweigt oder mit Halogenen (F, Cl, Br, I) substituiert sein kann, oder um einen Aryl-Rest (insbesondere Phenyl), der mit Alkyl-Gruppen, Halogenen (F, Cl, Br, I), Silan- (-SiR""₃) oder Ethergruppen -OR"" (R"" definiert wie R; die oben für die Lochtransport-Substituenten verwendeten Substituenten entsprechen nicht notwendiger Weise den Substituenten R der Formel A) substituiert sein kann. Ebenso kann es sich bei R um ungesättigte Gruppen wie Alkenyl- und Alkinyl-Gruppen handeln, die wiederum mit Alkyl-Gruppen, Halogenen (F, Cl, Br, I), Silan- (-SiR"₃) oder Ethergruppen -OR" (R" definiert wie R) substituiert sein können.

Zur Verwendung der Kupfer(I)-Komplexe als selbstkatalysierende Emittermaterialien zur Erzielung einer Quervernetzung mit einem zweiten Reaktanden können solche Funktionalitäten in der Peripherie des E∩N*- und/oder R₂D-B-DR₂-Liganden angebracht werden, die mit der entsprechend komplementären funktionellen Einheit des zweiten Reaktanden eine durch den Kupfer(I)-Komplex katalysierte Quervernetzung und somit Immobilisierung ermöglichen. Zusätzlich sorgt diese Quervernetzung für eine Stabilisierung und Fixierung der geometrischen Struktur der Metallkomplexe, wodurch eine Bewegung der Liganden und somit eine Strukturänderung der angeregten Moleküle verhindert und eine Effizienzminderung durch strahlungslose Relaxationspfade wirkungsvoll unterbunden wird.
Beispielhaft für eine selbstkatalysierte Quervernetzungsreaktion ist die Kupfer-katalysierte Click-Reaktion zwischen einem terminalen oder aktivierten Alkin als erster Click-Gruppe und einem Azid als zweiter Click-Gruppe. Da der Metallkomplex-Emitter in diesem Fall mindestens zwei Alkin-Einheiten tragen muss, sind entweder mindestens eine der Strukturen N*∩E oder R₂D-B-DR₂ in bevorzugter Weise mit mindestens zwei der oben genannten funktionellen Gruppe zur Erzielung einer Quervernetzung substituiert, oder mindestens beide der Strukturen N*∩E und R₂D-B-DR₂ mit mindestens je einer der oben genannten funktionellen Gruppe zur Erzielung einer Quervernetzung substituiert, während zusätzlich eine oder beide Einheiten N*∩E und/oder R₂D-B-DR₂ optional mit einer anderen der oben genannten funktionellen Gruppe zur Erhöhung der Löslichkeit des Komplexes in organischen Lösungsmitteln und/oder zur Verbesserung des Ladungsträgertransports substituiert sein kann.
Somit können unterschiedliche Funktionalitäten über die Peripherie der verschiedenen Liganden eingeführt werden (beispielsweise je eine Lochtransport- und Elektrontransport-Einheit zur Erzielung eines optimalen Ladungsträgertransports zu und eine wohldefinierte Rekombination direkt auf dem Kupferkomplex und/oder ein Substituent zur Erhöhung der Löslichkeit des Komplexes in organischen Lösungsmitteln und/oder eine funktionelle Gruppe zur Erzielung einer Quervernetzung), wodurch eine sehr flexible Anpassung und Modifizierung der Kupfer(I)-Komplexe möglich ist.

### Löslichkeit

Bei der Herstellung von opto-elektronischen Bauteilen mittels nass-chemischer Prozesse ist es vorteilhaft, die Löslichkeit gezielt einzustellen. Hierdurch kann das Auf- bzw. Anlösen einer bereits aufgebrachten Schicht vermieden werden. Durch das Einbringen spezieller Substituenten können die Löslichkeitseigenschaften stark beeinflusst werden. Dadurch ist es möglich, orthogonale Lösungsmittel zu verwenden, die jeweils nur die Substanzen des aktuellen Verarbeitungsschrittes lösen, aber nicht die Substanzen der darunter liegenden Schicht(en). Zu diesem Zweck können die Substituenten R des N*∩E-Liganden und/oder des Liganden R₂D-B-DR₂ so gewählt werden, dass sie eine Abstimmung der Löslichkeiten erlauben. Folgende Möglichkeiten zur Auswahl entsprechender Substituenten sind gegeben:

### Löslichkeit in unpolaren Medien

Unpolare Substitutenten R¹-R⁶ erhöhen die Löslichkeit in unpolaren Lösungsmitteln und erniedrigen die Löslichkeit in polaren Lösungsmitteln. Unpolare Gruppen sind z. B. Alkylgruppen [CH₃-(CH₂)ₙ-] (n = 1 - 30), auch verzweigte oder zyklische, substituierte Alkylgruppen, z. B. mit Halogenen. Hierbei sind besonders hervorzuheben: teil- oder perfluorierte Alkylgruppen sowie perfluorierte Oligo- und Polyether, z. B. [-(CF₂)₂-O]ₙ - und (-CF₂-O)ₙ- (n = 2 - 500). Weitere unpolare Gruppen sind: Ether -OR*, Thioether -SR*, unterschiedlich substituierte Silane R*₃Si-(R* = Alkyl oder Aryl), Siloxane R*₃Si-O-, Oligosiloxane R**(-R₂Si-O)ₙ- (R** = R*, n = 2 - 20), Polysiloxane R**(-R*₂Si-O)ₙ- (n > 20); Oligo/polyphosphazene R**(-R*₂P=N-)ₙ- (n = 1 -200).

### Löslichkeit in polaren Medien

Polare Substitutenten R¹-R⁶ erhöhen die Löslichkeit in polaren Lösungsmitteln. Diese können sein:
- Alkohol-Gruppen: -OH
- Carbonsäure-, Phosphonsäure-, Sulfonsäure-Reste sowie deren Salze und Ester (R* = H, Alkyl, Aryl, Halogen; Kationen: Alkalimetalle, Ammonium-Salze):
   - COOH, -P(O)(OH)₂, -P(S)(OH)₂, -S(O)(OH)₂, -COOR*, -P(O)(OR*)₂, -P(S)(OR*)₂ ,-S(O)(OR*)₂, -CONHR*, -P(O)(NR*₂)₂, -P(S)(NR*₂)₂, -S(O)(NR*₂)₂
- Sulfoxide: -S(O)R*, -S(O)₂R*
- Carbonylgruppen: -C(O)R*
- Amine: -NH₂, -NR*₂, -N(CH₂CH₂OH)₂,
- Hydroxylamine =NOR*
- Oligoester, -O(CH₂O-)ₙ, -O(CH₂CH₂O-)ₙ (n = 2 - 200)
- Positiv geladene Substituenten: z. B. Ammonium-Salze -N⁺R*₃X⁻, Phosphonium-Salze-P⁺R*3X⁻
- Negativ geladene Substituenten, z. B. Borate -(BR*₃)⁻, Aluminate -(AlR*₃)⁻ (als Anion kann ein Alkalimetal oder Ammoniumion fungieren).

Optional kann das Darstellungsverfahren den Schritt umfassen, dass mindestens ein Ligand N*∩E und/oder R₂D-B-DR₂ mit mindestens einem der oben genannten Substituenten zur Erhöhung der Löslichkeit in einem organischen Lösungsmittel substituiert wird, wobei der Substituent in einer Ausführungsform der Erfindung ausgewählt sein kann aus der Gruppe bestehend aus:
- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

Optional kann das Darstellungsverfahren den Schritt umfassen, dass mindestens ein Ligand N*∩E und/oder R₂D-B-DR₂ mit mindestens einer der o. g. funktionellen Gruppe zur Verbesserung des Ladungsträgertransports und zur Erhöhung der Rekombinationswahrscheinlichkeit der Ladungsträger direkt auf den erfindungsgemäßen Kupfer(I)komplexen substituiert wird, wobei die funktionelle Gruppe am Ligand N*∩E gleich oder verschieden sein kann von der funktionellen Gruppe am Ligand R₂D-B-DR₂, bevorzugt verschieden, wobei der Substituent in einer Ausführungsform der Erfindung ausgewählt sein kann aus der Gruppe bestehend aus Elektronenleiter und Lochleiter.

Erfindungsgemäß sind auch Kupfer(I)komplexe, die durch ein derartiges Syntheseverfahren herstellbar sind.

Die Kupfer(I)komplexe der Formel A können erfindungsgemäß als Emitter-Materialien in einer Emitterschicht eines Licht-emittierenden optoelektronischen Bauelements eingesetzt werden.

Die Kupfer(I)komplexe der Formel A können erfindungsgemäß auch als Absorber-Materialien in einer Absorberschicht eines optoelektronischen Bauelements eingesetzt werden.

Unter der Bezeichnung "optoelektronische Bauelemente" werden insbesondere verstanden:
- Organische Licht-emittierende Bauteile (organic light emitting diodes, OLEDs)
- Licht-emittierende elektrochemische Zellen (light emitting electrochemical cells, LECs, LEECs),
- OLED-Sensoren, insbesondere in nicht hermetisch nach außen abgeschirmten Gas- und Dampf-Sensoren,
- organische Solarzellen (organic solar cells, OSCs, organic photovoltaics, OPVs),
- Organische Feldeffekttransistoren und
- Organische Laser.

Der Anteil des Kupfer(I)komplexes in der Emitter- oder Absorber-Schicht in einem derartigen optoelektronischen Bauelement beträgt in einer Ausführungsform der Erfindung 100 %. In einer alternativen Ausführungsform beträgt der Anteil des Kupfer(I)komplexes in der Emitter- oder Absorber-Schicht 1 % bis 99 %.

Vorteilhafter Weise beträgt die Konzentration des Kupfer(I)komplexes als Emitter in optischen Licht emittierenden Bauelementen, insbesondere in OLEDs, zwischen 5 % und 80 %.

Gegenstand der vorliegenden Erfindung sind auch optoelektronische Bauelemente, die einen hier beschriebenen Kupfer(I)komplex aufweisen. Dabei kann das optoelektronische Bauelement ausgeformt sein als ein organisch lichtemittierendes Bauelement, eine organische Diode, eine organische Solarzelle, ein organischer Transistor, als eine organische Licht-emittierende Diode, eine Licht-emittierende elektrochemische Zelle, ein organischer Feldeffekttransistor und als ein organischer Laser.

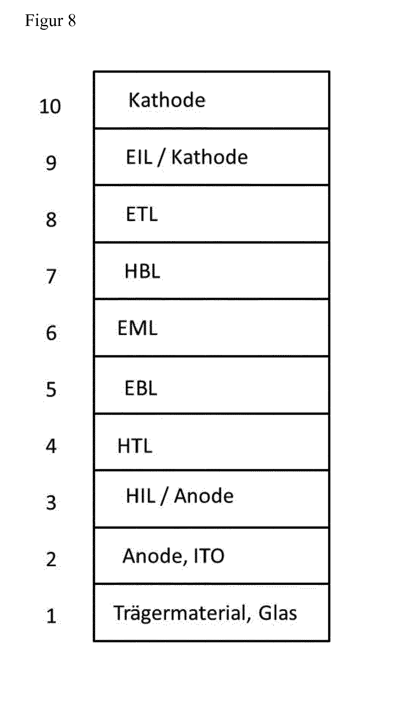

In einer Ausführungsform weist das genannte optoelektronische Bauelement ein Substrat (auch Trägermaterial genannt) auf und mindestens eine lichtemittierende Schicht, die einen Kupfer(I)komplex der hier beschriebenen Art aufweist, wobei die lichtemittierende Schicht auf das Substrat aufgebracht ist. Das Substrat kann dabei eine transparente Oberfläche sein, die bspw. aus Glas oder aus Plastik bestehen kann. Der entsprechende Aufbau ist in Figur 8 dargestellt.

In einer weiteren Ausführungsform weist das optoelektronische Bauelement eine Anode und eine Kathode auf, wobei die Anode und die Kathode auf das Substrat aufgebracht sind und die lichtemittierende Schicht zwischen Anode und Kathode aufgebracht ist.

In einer weiteren Ausführungsform weist die lichtemittierende Schicht des optoelektronischen Bauelements einen Kupfer(I)komplex der hier beschriebenen Art in 100 %iger Konzentration auf, bevorzugt in kristalliner oder mikrokristalliner Form.

In einer weiteren Ausführungsform weist die lichtemittierende Schicht des optoelektronischen Bauelements ein Hostmaterial auf, dessen Triplett (T1)- und Singulett (S1)-Energieniveaus energetisch höher liegen als die Triplett (T1)- und Singulett (S1)-Energieniveaus des beschriebenen Kupfer(I)komplexes.

In einer weiteren Ausführungsform weist das optoelektronische Bauelement mindestens je eine löcher- und elektroneninjizierende Schicht und mindestens je eine löcher- und elektronentransportierende Schicht auf, wobei die löcher- und elektroneninjizierende Schicht zwischen Anode und Kathode aufgebracht ist, und die löcher- und elektronentransportierende Schicht zwischen der löcher- und elektroneninjizierenden Schicht aufgebracht ist, und die lichtemittierende Schicht zwischen der löcher- und elektronentransportierenden Schicht aufgebracht ist.

In einem weiteren Aspekt betrifft die Erfindung ein lichtemittierendes Material, aufweisend einen Kupfer(I)komplex der hier beschriebnen Art und ein Hostmaterial, wobei die Triplett (T1)- und Singulett (S1)-Energieniveaus des Hostmaterials energetisch höher liegen als die Triplett (T1)- und Singulett (S1)-Energieniveaus des Kupfer(I)komplexes, und wobei das lichtemittierende Material Fluoreszenz oder thermisch aktivierte verzögerte Fluoreszenz emittiert, und einen ΔE(S1-T1)-Wert zwischen dem untersten angeregten Singulett (S1)- und dem darunter liegenden Triplett (T1)-Zustand von kleiner als 2000 cm⁻¹ aufweist.

Weiterhin betrifft die vorliegende Erfindung ein Verfahren zur Herstellung eines optoelektronischen Bauelements, wobei ein erfindungsgemäßer Kupfer(I)komplex der hier beschriebenen Art verwendet wird. Bei diesem Verfahren wird insbesondere ein erfindungsgemäßer Kupfer(I)komplex auf einen Träger aufgebracht. Dieses Aufbringen kann nass-chemisch, mittels kolloidaler Suspension oder mittels Sublimation erfolgen, insbesondere nass-chemisch. Das Verfahren kann die folgenden Schritte aufweisen:
Aufbringung eines in einem ersten Lösungsmittel gelösten ersten Emitterkomplexes auf einen Träger, und Aufbringung eines in einem zweiten Lösungsmittel gelösten zweiten Emitterkomplexes auf den Träger;
wobei der erste Emitterkomplexes nicht in dem zweiten Lösungsmittel löslich ist und der zweite Emitterkomplexes nicht in dem ersten Lösungsmittel löslich ist; und wobei der erste Emitterkomplex und/oder der zweite Emitterkomplex ein erfindungsgemäßer Kupfer(I)komplex ist. Das Verfahren kann weiterhin den folgenden Schritt aufweisen: Aufbringung eines in dem ersten Lösungsmittel oder in einem dritten Lösungsmittel gelösten dritten Emitterkomplexes auf den Träger, wobei der dritte Kupfer(I)komplex ein erfindungsgemäßer Kupfer(I)komplex ist. Erstes und zweites Lösungsmittel sind dabei nicht identisch.

Die vorliegende Erfindung betrifft auch ein Verfahren zur Veränderung der Emissions- und/oder Absorptionseigenschaften eines elektronischen Bauelements. Dabei wird ein erfindungsgemäßer Kupfer(I)komplex in ein Matrixmaterial zur Leitung von Elektronen oder Löchern in ein optoelektronisches Bauelement eingebracht.

Die vorliegende Erfindung betrifft auch die Verwendung eines erfindungsgemäßen Kupfer(I)komplexes, insbesondere in einem optoelektronischen Bauelement, zur Umwandlung von UV-Strahlung oder von blauem Licht in sichtbares Licht, insbesondere in grünes (490-575 nm), gelbes (575-585 nm), oranges (585-650 nm) oder rotes Licht (650-750 nm) (Down-Konversion).

In einer bevorzugten Ausführungsform ist die optoelektronische Vorrichtung eine Weißlicht-OLED, wobei der erste Emitterkomplex ein Rotlichtemitter ist, der zweite Emitterkomplex ein Grünlichtemitter ist und der dritte Emitterkomplex ein Blaulichtemitter ist. Der erste, zweite und/oder dritte Emitterkomplex ist bevorzugt ein erfindungsgemäßer Kupfer(I)komplex.

Da die erfindungsgemäßen Kupfer(I)komplexe mit unsubstituierten Liganden N*∩E in einigen organischen Lösungsmitteln z. T. schwer löslich sind, können sie ggf. nicht direkt aus Lösung verarbeitet werden. Bei Lösungsmitteln, die ihrerseits gute Liganden darstellen (Acetonitril, Pyridin) ist zwar eine gewisse Löslichkeit gegeben, jedoch kann eine Änderung der Struktur der Komplexe oder eine Verdrängung der Phosphan-, Arsan- oder Antimon-Liganden unter diesen Bedingungen nicht ausgeschlossen werden. Daher ist nicht klar, ob die Substanzen bei einer Abscheidung auf dem Substrat als Cu₂X*₂(E∩N*)R₂D-B-DR₂ kristallisieren bzw. ob sie in der Matrix in dieser Form molekular vorliegen werden. Aus diesem Grund sollten die Substanzen in einer für die Anwendung in optoelektronischen Bautelementen geeigneten Größe hergestellt bzw. auf diese zerkleinert werden (< 20 nm bis 30 nm, Nanopartikel) oder mittels geeigneter Substituenten löslich gemacht werden.

Die erfindungsgemäßen Kupfer(I)komplexe werden bevorzugt aus Lösung prozessiert, da das hohe Molekulargewicht eine Abscheidung aus dem Vakuum durch Sublimation erschwert. Somit erfolgt die Herstellung der photoaktiven Schichten bevorzugt aus Lösung durch Spincoating oder Schlitzgießverfahren oder mit einem beliebigen Druckverfahren wie Siebdruck, Flexodruck, Offsetdruck oder Ink-Jet-Druck.

Die hier beschriebenen unsubstituierten Kupfer(I)komplexe (Definition weiter unten, siehe Beispiele) sind jedoch in den gängigen organischen Lösungsmitteln, außer in Dichlormethan, welches zur OLED-Bauteilherstellung in einer Glovebox nicht verwendet werden sollte, schwer löslich. Das Aufbringen als kolloidale Suspension ist in vielen Fällen sinnvoll (siehe weiter unten), allerdings ist eine technische Verarbeitung der Emittermaterialien in gelöster Form meist technisch einfacher. Daher ist ein weiteres Ziel dieser Erfindung, die Emitter chemisch so zu verändern, dass diese löslich sind. Geeignete Lösungsmittel für die OLED-Bauteilherstellung sind neben Alkoholen, Ethern, Alkanen sowie halogenierten aromatischen und aliphatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Um die Löslichkeit der erfindungsgemäßen Kupfer(I)komplexe in organischen Lösungsmitteln zu verbessern, ist mindestens eine der Strukturen N*∩E und/oder R₂D-B-DR₂ in bevorzugter Weise mit mindestens einem der oben genannten Substituenten substituiert. Der Substituent kann ausgewählt sein aus der Gruppe bestehend aus:
- langkettigen, verzweigten oder unverzweigten oder zyklischen Alkylketten mit einer Länge von C1 bis C30, bevorzugt mit einer Länge von C3 bis C20, besonders bevorzugt mit einer Länge von C5 bis C15,
- langkettigen, verzweigten oder unverzweigten oder zyklischen, Alkoxyketten einer Länge von C1 bis C30, bevorzugt mit einer Länge von C3 bis C20, besonders bevorzugt mit einer Länge von C5 bis C15,
- verzweigten oder unverzweigten oder zyklischen Perfluoralkylketten einer Länge von C1 bis C30, bevorzugt mit einer Länge von C3 bis C20, besonders bevorzugt mit einer Länge von C5 bis C15 und
- kurzkettigen Polyethern, wie z. B. Polymere der Form (-OCH₂CH₂O-)ₙ, mit n < 500. Beispiele hierfür sind Polyethylenglykole (PEG), die als chemisch inerte, wasserlösliche und nicht-toxische Polymere mit einer Kettenlänge von 3-50 Wiederholungseinheiten eingesetzt werden können.

Die Alkylketten oder Alkoxylketten oder Perfluoralkylketten sind in einer bevorzugten Ausführungsform der Erfindung mit polaren Gruppen modifiziert, z. B. mit Alkoholen, Aldehyden, Acetale, Aminen, Amidine, Carbonsäuren, Carbonsäureestern, Carbonsäureamide, Imide, Carbonsäurehalogenide, Carbonsäureanhydride, Ethern, Halogenen, Hydroxamsäuren, Hydrazine, Hydrazone, Hydroxylamine, Laktone, Laktame, Nitrilen, Isocyanide, Isocyanate, Isothiocyanate, Oxime, Nitrosoaryle, Nitroalkyle, Nitroaryle, Phenole, Phosphorsäureestern und/oder Phosphonsäuren, Thiolen, Thioethern, Thioaldehyde, Thioketone, Thioacetale, Thiocarbonsäuren, Thioester, Dithiosäure, Dithiosäureester, Sulfoxide, Sulfone, Sulfonsäure, Sulfonsäureester, Sulfinsäure, Sulfinsäureester, Sulfensäure, Sulfensäureester, Thiosulfinsäure, Thiosulfinsäureester, Thiosulfonsäure, Thiosulfonsäureester, Sulfonamide, Thiosulfonamide, Sulfinamide, Sulfenamide, Sulfate, Thiosulfate, Sultone, Sultame, Trialkylsilyl- und Triarylsilyl-Gruppen sowie Trialkoxysilyl-Gruppen, die eine weitere Erhöhung der Löslichkeit zur Folge haben.

Eine sehr ausgeprägte Erhöhung der Löslichkeit wird ab mindestens einer C6-Einheit, verzweigt oder unverzweigt oder zyklisch, erreicht.

Um den Ladungsträgertransport und die Rekombinationswahrscheinlichkeit der Ladungsträger direkt auf den erfindungsgemäßen Kupfer(I)komplexen zu verbessern, ist mindestens eine der Strukturen N*∩E und/oder R₂D-B-DR₂ in bevorzugter Weise mit mindestens einer der oben genannten funktionellen Gruppe zur Verbesserung des Ladungsträgertransports substituiert, wobei die funktionelle Gruppe am Ligand N*∩E gleich oder verschieden sein kann von der funktionellen Gruppe am Ligand R₂D-B-DR₂, bevorzugt verschieden. Der Substituent kann ausgewählt sein aus der Gruppe bestehend aus Elektronenleiter und Lochleiter.

Die Substituenten der Strukturen N*∩E und/oder R₂D-B-DR₂ der Kupfer(I)komplexe können an jeder Stelle der Struktur angeordnet sein. Insbesondere ist eine Stellung des Substituenten in ortho-, meta- und/oder para-Stellung zu dem die Koordination zum Cu-Ion ausbildenden Heteroatom möglich. Bevorzugt ist eine Substitution in meta- und/oder para-Stellung.

Ein weiterer Aspekt der Erfindung betriff die Veränderung der Emissionsfarbe der Kupfer(I)komplexe mittels elektronenschiebender oder -ziehender Substituenten oder mittels kondensierter N-Heteroaromaten. Die Begriffe elektronenschiebend und elektronenziehend sind dem Fachmann bekannt.

Beispiele für elektronenschiebende Substituenten sind insbesondere:
- Alkyl, -Phenyl, -CO₂(-), -O(-), -NH-Alkylgruppe, -N-(Alkylgruppe)₂, -NH₂, -OH, -O-Alkylgruppe, -NH(CO)-Alkylgruppe, -O(CO)-Alkylgruppe, -O(CO)-Arylgruppe, -O(CO)-Phenylgruppe, -(CH)=C-(Alkylgruppe)₂, -S-Alkylgruppe

Beispiele für elektronenziehende Substituenten sind insbesondere:
- Halogen, -(CO)H, -(CO)-Alkylgruppe, -(CO)O-Alkylgruppe, -(CO)OH,-(CO)Halogenid, -CF₃, -CN, -SO₃H, -NH₃(+), -N(Alkylgruppe)₃(+), -NO₂

Vorteilhafter Weise sind die elektronenschiebenden und -ziehenden Substituenten möglichst weit von der Koordinationsstelle des Liganden entfernt, insbesondere in meta- oder para-Stellung.

Somit kann durch geeignete Substitutionswahl beispielsweise innerhalb der Grundstruktur eines Pyridinliganden ein sehr breiter Emissionsfarbbereich eingestellt werden.

Die Veränderung der Emissionsfarben der hier beschriebenen Kupfer(I)komplexe kann auch durch weitere Heteroatome wie N, O, S, sowie mittels kondensierter N-, O- und S-Heteroaromaten erfolgen.

Die Verwendung kondensierter N-Heteroaromaten wie beispielsweise Isoquinolin, Benzothiazol, Chinoxalin, ermöglicht Farbverschiebungen, zum Beispiel in den gelben bis tiefroten Spektralbereich. Die Erhöhung der Löslichkeit von Kupfer(I)komplexen mit kondensierten N-Heteroaromaten kann ebenfalls durch Substitution(en) mit den oben beschriebenen Substituenten, langkettigen (verzweigten oder unverzweigten oder zyklischen) Alkylketten einer Länge von C1 bis C30, bevorzugt mit einer Länge von C3 bis C20, besonders bevorzugt mit einer Länge von C5 bis C15, langkettigen (verzweigten oder unverzweigten oder zyklischen) Alkoxyketten einer Länge von C1 bis C30, bevorzugt mit einer Länge von C3 bis C20, besonders bevorzugt mit einer Länge von C5 bis C15, langkettigen (verzweigten oder unverzweigten oder zyklischen) Perfluoralkylketten einer Länge von C1 bis C30, bevorzugt mit einer Länge von C3 bis C20, besonders bevorzugt mit einer Länge von C5 bis C15 und kurzkettigen Polyethern (Kettenlänge: 3-50 Wiederholungseinheiten) erfolgen.

In einer bevorzugten Ausführungsform weist der erfindungsgemäße Kupfer(I)komplex mindestens einen Substituenten zur Erhöhung der Löslichkeit in einem organischen Lösungsmittel auf und/oder mindestens einen elektronenschiebenden und/oder mindestens einen elektronenziehenden Substituenten. Es ist auch möglich, dass ein die Löslichkeit verbessernder Substituent gleichzeitig entweder ein elektronenschiebender oder -ziehender Substituent ist. Ein Beispiel für einen derartigen Substituenten ist ein dialkyliertes Amin mit elektronenschiebender Wirkung über das Stickstoffatom und löslichkeits-erhöhender Wirkung durch die langkettigen Alkylgruppen.

Mittels einer modularen Synthesestrategie, in der die Einzelbausteine zur Darstellung dieser Liganden in einer Matrix miteinander kombiniert werden, ist die Einführung von unterschiedlich langen, linearen und verzweigten und zyklischen Alkylketten, Alkoxyketten oder Perfluoralkylketten an verschiedenen Positionen der Moleküle möglich. Bevorzugt sind Substitutionen, die weit entfernt sind von der Koordinationsstelle des oder der Liganden N*∩E und/oder R₂D-B-DR₂.

Ausgehend von einem geeigneten allgemeinen Synthesebaustein A werden in analogen Reaktionen unterschiedliche allgemeine Reaktanden B, C und D unter analogen Reaktionsbedingungen zu chemisch diversen allgemeinen Zielmolekülen AB, AC und AD verknüpft. AB, AC und AD meint hierbei, dass eine neue Bindung zwischen dem allgemeinen Synthesebaustein A und den allgemeinen Reaktanden B, C und D ausgebildet wird und so ein neues Molekül bestehend aus A und B bzw. A und C bzw. A und D entsteht. Hierdurch lassen sich beispielsweise unterschiedlich lange Alkylketten durch Verwendung nukleophiler Substitutionsreaktionen modular an einen geeigneten Pyridinliganden anbringen

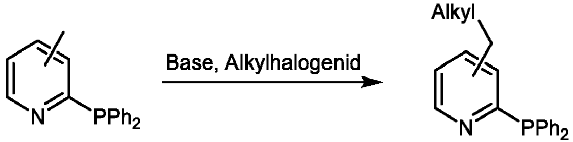

Für die Herstellung der oben genannten Nanopartikel kleiner als 30 nm können mehrere Techniken angewandt werden (A. Rössler, G. Skillas, S. E. Pratsinis, Chemie in unserer Zeit 2001, 35, 32):
*Bottorna-Up-Prozesse* zur Synthese von Nanopartikeln:
   - schnelle Injektion der Reaktionslösung in einen großen Überschuss eines geeigneten Fällungsmittel (z. B. Pentan, Diethylether). (Y. Sun, K. Ye, H. Zhang, J. Zhang, L. Zhao, B. Li, G. Yang, B. Yang, Y. Wang, S.-W. Lai, C.-M. Che, Angew. Chem. 2006, 118, 5738.)
   - Feine Zerstäubung der Reaktionslösung in einer Vakuumkammer, eventuell unter erhöhter Temperatur (Sprühtrocknung). Dabei verdampft das Lösungsmittel und der Komplex bleibt in feinverteilter Form zurück.
   - Im Gefriertrocknungsverfahren werden die Tropfen der Reaktionslösung in einem Kühlmittel (z. B. flüssiger Stickstoff) dispergiert, wobei das Material gefriert. Anschließend wird es im festen Zustand getrocknet.
   - Co-Abscheidung der Komplexe und des Matrixmaterials auf dem Substrat direkt aus der Reaktionslösung.
   - Synthese im Ultraschall-Bad.

*Top-Down*-Prozesse zur Zerkleinerung der Substanzen:
- Zerkleinerung durch Hochenergiekugelmühlen (Y. Chen, J. F. Gerald, L. T. Chadderton, L. Chaffron, Appl. Phys. Lett. 1999, 74, 2782).
- Zerkleinerung durch hochintensiven Ultraschall.

Eine Isolierung der benötigten Partikelgröße kann durch Filtration mit geeigneten Filtern oder durch Zentrifugation erreicht werden.

Um eine homogene Verteilung der Nanopartikel in der Matrix (z. B. des im Emitter-Layer verwendeten Matrixmaterials) zu erreichen, wird eine Suspension in einem Lösungsmittel zubereitet, in der sich das Matrixmaterial löst. Durch die üblichen Verfahren (z. B. Spin-Coating, Tintenstrahldruck, etc.) kann mit dieser Suspension das Matrixmaterial und die Nanopartikel auf ein Substrat aufgebracht werden. Um eine Aggregation der Nanopartikel zu vermeiden, kann unter Umständen eine Stabilisierung der Teilchen durch oberflächenaktive Substanzen notwendig sein. Diese sind jedoch so zu wählen, dass die Komplexe nicht aufgelöst werden. Eine homogene Verteilung kann auch durch die oben erwähnte Co-Abscheidung der Komplexe zusammen mit dem Matrixmaterial direkt aus der Reaktionslösung erreicht werden.

Da die beschriebenen Substanzen sogar als Feststoffe eine hohe Emissionsquantenausbeute besitzen, können sie ausgehend von der Reaktionslösung auch direkt als dünne Schicht (100 % Emitterschicht) auf dem Substrat abgeschieden werden.

### Figuren

Es zeigen:
Figur 1: eine schematische und vereinfachte Darstellung einer organischen Licht-emittierenden Diode (OLED);
Figur 2: zur Synthese von überbrückten -Komplexen geeignete verschiedene N,P-Liganden sowie verschiedene überbrückende Liganden;
Figur 3: Grenzorbitalbetrachtung für Komplex 1-I-o;

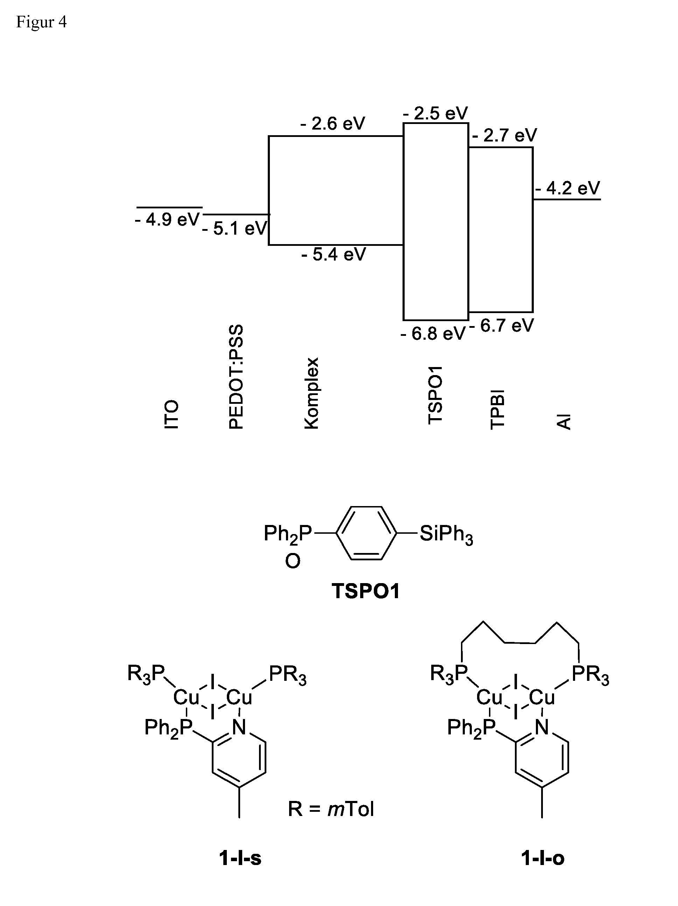

Figur 4: ein Energieniveau-Diagramm für das Bauteil ITO(130 nm)//PEDOT:PSS (30 nm)//Komplex (30 nm)//TSP01 (15 nm)//TPBi (15 nm)//LiF(1 nm)//Al(100 nm) (oben).
Figur 5: (links) Vergleich des Photolumineszenzspektrum (gepunktet) sowie des Elektrolumineszenzspektrums (durchgezogene Linie) von 1-I-s (Stack: siehe Figur 4) (rechts) L-I-V Kurve für 1-I-s;
Figur 6: ein Energieniveau-Diagramm für das Bauteil ITO(130 nm)//PEDOT:PSS (30 nm)//UT-314 (45nm)// Komplex 1-I-O/hl (30/70) (40 nm)//3TYPMB (15 nm)//LiF(2 nm)//Al(100 nm) (oben). Strukturen der in diesem Stack verwendeten Materialien. (unten);
Figur 7: eine Strom-Spannungs-Kennlinie (U-I-Kennlinie) (oben) und ein Effizienzdiagramm für 1-I-o mit UT-314 als HTL (unten).
Figur 8: Schematischer Aufbau eines optoelektronischen Bauelements in Form einer OLED (EIL: Elektroneninjektionsschicht; ETL: Elektronentransportschicht; HBL: Löcherblockierungsschicht; EML: Emissionsschicht; EBL: Elektronenblockierungsschicht; HTL: Löchertransportschicht; HIL: Löcherinjektionsschicht; ITO: Indiumzinnoxid).

### Beispiele

In den hier gezeigten Beispielen ist der Ligand E∩N* der allgemeinen Formel A ein Ligand P∩N* (mit E = Ph₂P).

**Allgemeine Arbeitsvorschrift AAV: AAV 1 Herstellung von Komplexen: Cu₂X₂(N,P)(R₂D-B-DR₂)** Das entsprechende Kupfersalz (1.00 Äquiv., 1.00 mmol), die Liganden (N,P-Ligand: 0.50 Äquiv., 0.50 mmol sowie R₂D-B-DR₂: 1.00 equiv, 1.00 mmol) werden unter Stickstoff in einem 20 mL Crimp-Vial mit Rührfisch vorgelegt. Die Mischung wird mit 10 mL trockenem Dichlormethan versetzt. Die Reaktion wird gerührt bis eine klare, zumeist gelbe Lösung vorlag. Die Reaktionsmischung wurde über einen Spritzenfilter (0.45 µm) filtriert und in mind. 50-fachem Volumenüberschuss Methanol, Diethylether oder n-Hexan ausgefällt. Die Produkte wurden abfiltriert und unter vermindertem Druck getrocknet.
Die Identitäten und Strukturen der Komplexe wurden eindeutig durch NMR-Spektroskopie, Massenspektrometrie, Elementaranalysen und/oder Kristallstrukturanalysen (s. Figur 1A) Welche Strukturen sind hier gemeint? belegt.

### Beispiele für Komplexe der Form Cu₂X₂(P∩N*)R₂D-B-DR₂

*(MePyrPHOS)(1,6-Bisdiphenylphosphino-hexan)Cu₂I₂* **(1-I-n).** Die Titelverbindung wurde nach AAV 1 synthetisiert, aus n-Hexan ausgefällt und mit 50 mL Diethylether gewaschen sowie unter vermindertem Druck getrocknet. Hellgelbes Pulver (86% Ausbeute). - ¹H NMR (500 MHz, Chloroform-*d*) δ = 7.88 - 7.29 (m, 18H), 7.28-6.96 (m, 15H), 2.46 - 2.23 (m, 6H), 1.43 (m, 9H) ppm. - ³¹P NMR (202 MHz, Chloroform-*d*) δ = -3.9, -15.3, -21.1 ppm. - IR (ATR): ν = 3049 (vw), 2925 (vw), 2847 (vw), 1586 (vw), 1481 (w), 1458 (vw), 1433 (m), 1406 (vw), 1185 (vw), 1157 (vw), 1099 (vw), 1069 (m), 1046 (vw), 1027 (vw), 999 (vw), 977 (vw), 944 (vw), 858 (vw), 788 (vw), 733 (vs), 691 (vs), 521 (m), 507 (s), 477 (s), 449 (s), 423 (s) cm⁻¹. - FAB-MS m/z (%): 340 [CuL⁺], 517 [CuP₂⁺], 617 [CuL₂⁺], 707 [Cu₂IP₂⁺], 806 [Cu₂IL₂⁺], 898 [Cu₃I₂P₂⁺], 997 [Cu₂IP₂L⁺]. C₄₈H₄₈Cu₂I₂NP₃ ber. C 51.81, N 1.26, H 4.35 gef. C 52.21, N 1.01, H 4.44.

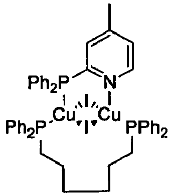

*(MePyrPHOS)(1,5-Bisdiphenylphosphino-pentan)Cu₂I₂* **(1-I-o).** Die Titelverbindung wurde nach AAV 1 synthetisiert, aus n-Hexan ausgefällt und mit 50 mL Diethylether gewaschen sowie unter vermindertem Druck getrocknet. Hellgelbes Pulver (80% Ausbeute). ¹H NMR (500 MHz, Chloroform-*d* δ = 8.81 (bs, 1H), 7.82 - 7.66 (m, 2H), 7.63 - 7.54 (m, 2H), 7.54 - 7.43 (m, 3H), 7.38 (s, 1H), 7.33 (d, J = 7.8 Hz, 9H), 7.27 - 7.18 (m, 11H), 7.14 - 7.01 (m, 6H), 2.56 - 2.40 (m, 3H), 2.25 (s, 3H), 1.74 - 1.62 (m, 2H), 1.39 (dd, J = 8.0, 4.1 Hz, 1H) ppm. - ³¹P NMR (202 MHz, Chloroform-*d*) δ = -4.0, -21.8 ppm. - IR (ATR): ν = 3049 (vw), 2936 (vw), 1587 (vw), 1481 (w), 1433 (m), 1308 (vw), 1184 (vw), 1157 (vw), 1096 (m), 1027 (vw), 999 (vw), 827 (vw), 738 (vs), 692 (vs), 618 (vw), 553 (vw), 512 (s) 496 (s), 463 (s) cm⁻¹. - FAB-MS *m*/*z* (%): 340 [CuL⁺], 502 [CuP₂⁺], 617 [CuL₂⁺], 693 [Cu₂IP₂⁺], 884 [Cu₃I₂P₂⁺], 970 [Cu₂ILP₂⁺]. - C₄₇H₄₆Cu₂I₂NP₃ x DCM ber. C 48.71, N 1.18, H 4.22 gef. C 48.36, N 1.18, H 3.97.

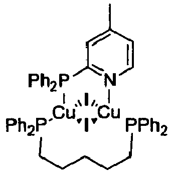

*(MePyrPHOS)(1,3-Bisdiphenylphosphino-xylol)Cu₂I₂* **(1-I-p).** Die Titelverbindung wurde nach AAV 1 synthetisiert, aus n-Hexan ausgefällt und mit 50 mL Diethylether gewaschen sowie unter vermindertem Druck getrocknet. Hellgelbes Pulver (63% Ausbeute). -1H NMR (500 MHz, Chloroform-*d*) δ = 8.51 (s, 1H), 7.70 - 7.30 (m, 16H), 7.24 - 6.86 (m, 20H), 3.76 - 3.53 (m, 4H), 2.26 (s, 3H) ppm. - ³¹P NMR (202 MHz, Chloroform-*d*) δ = -10.23, -28.66 ppm. - C₅₀H₄₄Cu₂I₂NP₃ x DCM ber. C 50.31, N 1.15, H 3.81 gef. C 50.07, N 0.51, H 3.78.

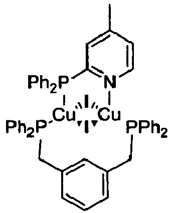

*(MePyrPHOS)(1,4-Bis((diphenylphosphanyl)oxy)benzol)Cu₂I₂* **(1-I-q).** Die Titelverbindung wurde nach AAV 1 synthetisiert, aus n-Hexan ausgefällt und mit 50 mL Diethylether gewaschen sowie unter vermindertem Druck getrocknet. Hellgelbes Pulver (36% Ausbeute). - *Der Komplex zeigte in Lösung eine hohe Oxidationsempfindlichkeit. Zufriedenstellende NMR-Spektren konnten aus diesem Grund nicht erhalten werden. -* IR (ATR): ν = 3300 (vw), 3049 (vw), 2925 (vw), 2849 (vw), 1587 (vw), 1493 (vs), 1433 (s), 1184 (vs), 1096 (m), 1027 (w), 870 (m), 831 (w), 738 (s), 692 (vs), 665 (w), 516 (vs), 463 (m), 439 (w) cm⁻¹. - FAB-MS *m*/*z* (%): 340 [CuL⁺], 530 [Cu₂IL⁺], 541 [CuP₂⁺], 617 [CuL₂⁺], 721 [Cu₃I₂L⁺], 731 [Cu₂IP₂⁺], 809 [Cu₂IL₂⁺]; 999 [Cu₃I₂L₂⁺], 1009 Cu₂ILP₂⁺]. C₄₈H₄₀NO₂P₃Cu₂I₂: ber. C 50.72, N 1.23, H 3.55 gef. C 50.41, N 0.87, H 3.44.

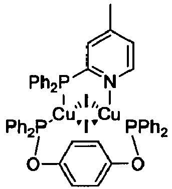

*(MePyrPHOS)(1,3-Bis((diphenylphosphanyl)oxy)benzol)Cu₂I₂* **(1-I-r).** Die Titelverbindung wurde nach AAV 1 synthetisiert, aus n-Hexan ausgefällt und mit 50 mL Diethylether gewaschen sowie unter vermindertem Druck getrocknet. Hellgelbes Pulver (40%

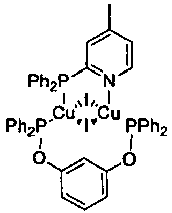

Ausbeute). - *Der Komplex zeigte in Lösung eine hohe Oxidationsempfindlichkeit. Zufriedenstellende NMR*-*Spektren konnten aus diesem Grund nicht erhalten werden. -* IR (ATR): ν = 3305 (vw), 3051 (vw), 2923 (vw), 2849 (vw), 1587 (vw), 1494 (vs), 1433 (s), 1182 (vs), 1096 (m), 1027 (w), 870 (m), 831 (w), 738 (s), 692 (vs), 666 (w), 515 (vs), 463 (m), 440 (m) cm⁻¹. - FAB-MS *m*/*z* (%): 340 [CuL⁺], 530 [Cu₂IL⁺], 541 [CuP₂⁺], 617 [CuL₂⁺], 721 [Cu₃I₂L⁺], 733 [Cu₂IP₂⁺], 809 [Cu₂IL₂⁺], 998 [Cu₃I₂L₂⁺], 1009 [Cu₂ILP₂⁺]. - C₄₈H₄₀NO₂P₃Cu₂I₂ x ⅓DCM ber. C 49.83, N 1.26, H 3.90 gef. C 49.65, N 0.92, H 3.90.

*(1-butyl-5-(diphenylphosphino)-1H-1,2,4-triazol)(1,6-Bisdiphenylphosphino-hexan)Cu₂I₂* **(7-I-0)**. Der Komplex wurde nach AAV 1 hergestellt und zur Aufreinigung aus Diethylether ausgefällt und für 24 bei Raumtemperatur am Hochvakuum getrocknet. Farbloses Pulver (65 % Ausbeute). - ¹H NMR (500 MHz, Chloroform-*d*) δ = 7.88 (bs, 1H, triazol-H), 7.83 - 6.89 (m, 30H, Ar-H), 3.71 (m, 2H, N-CH₂), 2.61 - 1.33 (m, 13H, CH₂), 1.10 (s, 2H, CH₂), 0.96 - 0.77 (m, 2H, CH₂), 0.61 (s, 3H, CH₃) ppm. - ³¹P NMR (250 MHz, Chloroform-*d*): δ = -12.1 (TriazPHOS), -15.3 (dpph) ppm. - IR (ATR) 3049 (vw), 2930 (vw), 1979 (vw), 1586 (vw), 1481 (m), 1434 (s), 1309 (vw), 1284 (vw), 1179 (vw), 1097 (m), 1027 (vw), 998 (vw), 740 vs), 693 (vs), 531 (s), 510 (s), 479 (s), 450 (m) cm⁻¹. - FAB-MS *m*/*z* (%): 1349 [Cu₃I₂LP⁺], 1158 [Cu₂I₂LP⁺], 707 [Cu₂LP⁺], 562 [Cu₂IL⁺], 517 [CuP⁺], 372 [CuL⁺]. - C₄₈H₅₂N₃Cu₂I₂P₃ × ⅓ DCM(1143.01): ber. C 49.49, H 4.53, N 3.56; gef. C 49.89, H 4.37, N 3.14.

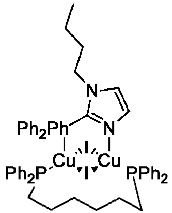

*(2-Diphenylarsino-4-methyl-pyridin)(1,4-Bis((diphenylphosphanyl)oxy)benzol)Cu₂I₂* **(9-I-q).** Der Komplex wurde nach AAV 1 hergestellt und zur Aufreinigung aus Diethylether ausgefällt und für 24 bei Raumtemperatur am Hochvakuum getrocknet. Farbloses Pulver (42 % Ausbeute). - *Der Komplex zeigte in Lösung eine hohe Oxidationsempfindlichkeit. Zufriedenstellende NMR*-*Spektren konnten aus diese Grund nicht erhalten wenden. -* IR (ATR): ν = 3049 (vw), 1596 (w), 1495 (m), 1435 (m), 1185 (s), 1131 (w), 1099 (m), 998 (w), 875 (m), 831 (m), 740 (s), 691 (vs), 519 (s), 472 (m), 439 (w) cm⁻¹. - FAB-MS *m*/*z* (%): 384 [CuL⁺], 541 [CuP₂⁺], 574 [Cu₂IL⁺], 731 [Cu₂IP₂⁺], 765 [Cu₃I₂L⁺], 862 [CuLP₂⁺], 922 [Cu₃I₂P₂⁺]. - C₄₈H₅₀NP₂AsO₂Cu₂I₂ × 1.5 DCM: ber. C 45.45, N. 107, H 3.31; gef. C 44.65, N 0.70, H 3.31.

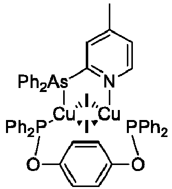

(*PyrPHOS*)(*1,6*-*Bisdiphenylphosphino*-*hexan*)*Cu₂I₂* **(11-I-o):** Der Komplex wurde nach AAV 1 hergestellt und zur Aufreinigung aus *n*-Hexan ausgefällt und für 24 bei Raumtemperatur am Hochvakuum getrocknet. Ausbeute: 69 %, 692 µmol, 760 mg, hellgelbes Pulver. - ¹H NMR (500 MHz, Chloroform-*d*) δ = 8.71 (s, 1H), 7.77 - 7.29 (m, 19H), 7.15 (d, *J* = 61.7 Hz, 13H), 2.67 - 2.23 (m, 4H), 1.98 - 1.34 (m, 9H) ppm. - ³¹P NMR (202 MHz, Chloroform-*d*) δ = -4.5 (PyrPHOS), -21.0 (dpph) ppm.-FAB-MS *m*/*z* (%): 326 [CuY⁺], 517 [Cu₂IY⁺], 519 [CuP⁺], 535 [CuY₂⁺], 707 [Cu₃I₂Y⁺], 710 [Cu₂IP⁺], 899 [Cu₄I₃Y⁺], 901 [Cu₃I₂P⁺], 970 [Cu₂IYP⁺], 1162 [Cu₃I₂YP⁺], 1353 [Cu₃I₂YP⁺], [Cu₂BrP⁺]. - IR (ATR) 3049 (vw), 2926 (vw), 2848 (vw), 1572 (vw), 1481 (w), 1453 (vw), 1433 (m), 1311 (vw), 1185 (vw), 1157 (vw), 1097 (w), 1027 (w), 999 (vw), 858 (vw), 736 (vs), 692 (vs), 508 (vs), 478 (s), 449 (m), 423 (w) cm⁻¹. - C₄₇H₄₆NCu₂I₂P₃ (1096.95): ber. C 51.39, H 4.22, N 1.27; gef. C 51.41, H 4.12, N 0.90. 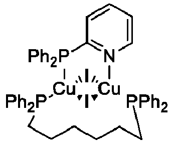 **P∩N*** = **Ph₂P(Oxadiazol), R₂D-B-DR₂** = **PhP(CH₂CH₂PPh₂)₂: Cu₂I₂(Ph₂P(Oxadiazol))(PhP(CH₂CH₂PPh₂)₂)₂ (12)**

Bei der Verbindung 12 handelt es sich um einen gelben, feinkristallinen Feststoff. Synthese siehe AAV 1.

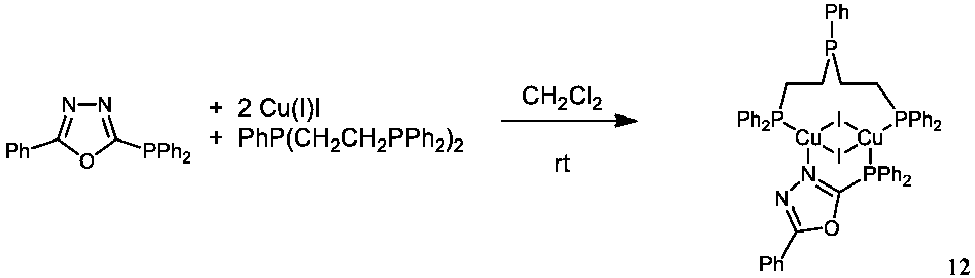

### Charakterisierung:

Elementaranalyse:
   gef.: C 49.84; H 3.76 N 1.67
   (mit einem Molekül DCM)
   ber.: C 49.64; H 3.79; N 2.11

Das Emissionsspektrum ist in **Fig. 12** gezeigt.

**P∩N*** = **Ph₂P(MeTolImid), R₂D-B-DR₂ = DPEphos: Cu₂I₂(Ph₂P(MeTolImid)(PPEphos) (37)**

Bei der Verbindung 37 handelt es sich um einen weißen, feinkristallinen Feststoff. Synthese siehe AAV 1.

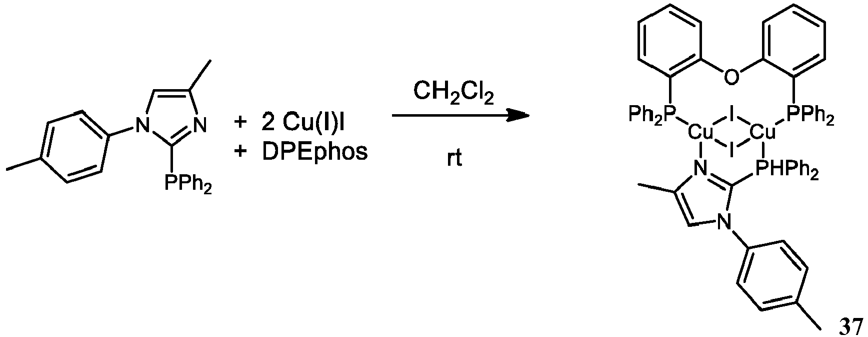

### Charakterisierung:

Elementaranalyse:
   gef.: C 48.62; H 3.38; N 3.01
   (mit 1 Molekül DCM)
   ges.: C 48.50; H 3.44; N 3.26

### P∩N* = Ph₂P(TolOxadiazol), R₂D-B-DR₂ = DPEphos: Cu₂I₂(Ph₂P(Oxadiazol)(DPEphos) (38)

Bei der Verbindung **38** handelt es sich um einen weißen, feinkristallinen Feststoff. Synthese siehe AAV1.

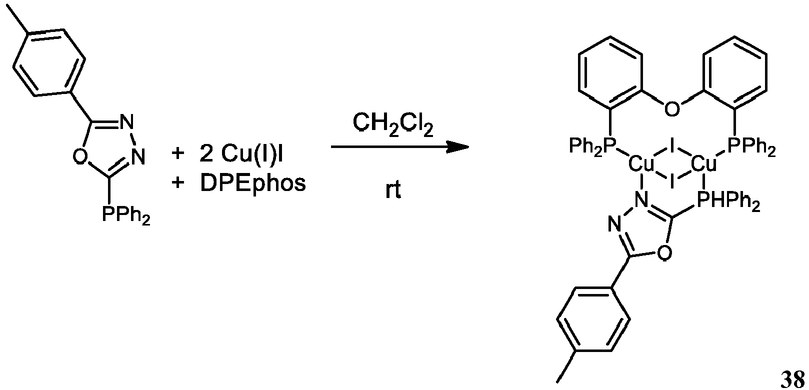

### Charakterisierung:

Elementaranalyse:
   gef.: C 51.00; H 3.46; N 2.22
   ges.: C 50.89; H 3.43; N 2.33

**P∩N*** = **Ph₂P(Ph₂PThiaz), R₂D-B-DR₂ = DPEphos: Cu₂I₂(Ph₂P(Ph₂PThiaz)(DPEphos) (39)**

Bei der Verbindung **39** handelt es sich um einen weißen, feinkristallinen Feststoff. Synthese siehe AAV1.

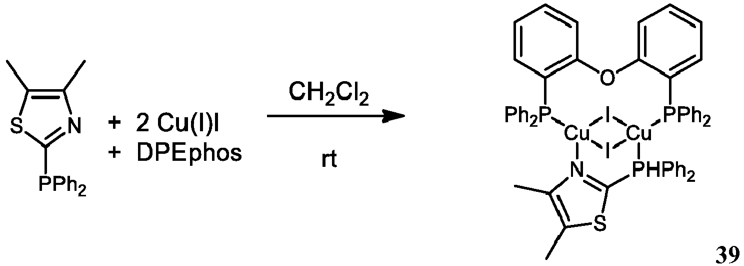

### Charakterisierung:

Elementaranalyse:
   gef.: C 48.57; H 3.43; N 1.03; S 2.74
   ges.: C 48.80; H 3.49; N 1.21; S 2.77

### OLED-Bauteile

Die OLED-Architektur wurde zunächst stark vereinfacht: Es wurden Bauteile ohne die Verwendung von zusätzlichen Hostmaterialien hergestellt. Die EML bestand in diesen Experimenten lediglich aus Reinfilmen der Komplexe. Um Quenching durch benachbarte Grenzschichten mit niedriger Triplett-Energie zu vermeiden, wurde die Lochleitschicht weg gelassen und eine Blockschicht zwischen Emissionsschicht (EML) und Elektronentransportschicht (ETL) eingebracht. Die Lochleitschicht poly-TPD wurde aufgrund ihrer niedrigen Triplet-Energie weggelassen, außerdem wurde eine zusätzliche Blockierschicht aus TSPO1 zwischen ETL und EML eingeführt. TSPO1 ist kommerziell erhältlich und verfügt über eine Triplett-Energie von 3,4 eV, sodass Quenchingprozesse hier ausgeschlossen sind.

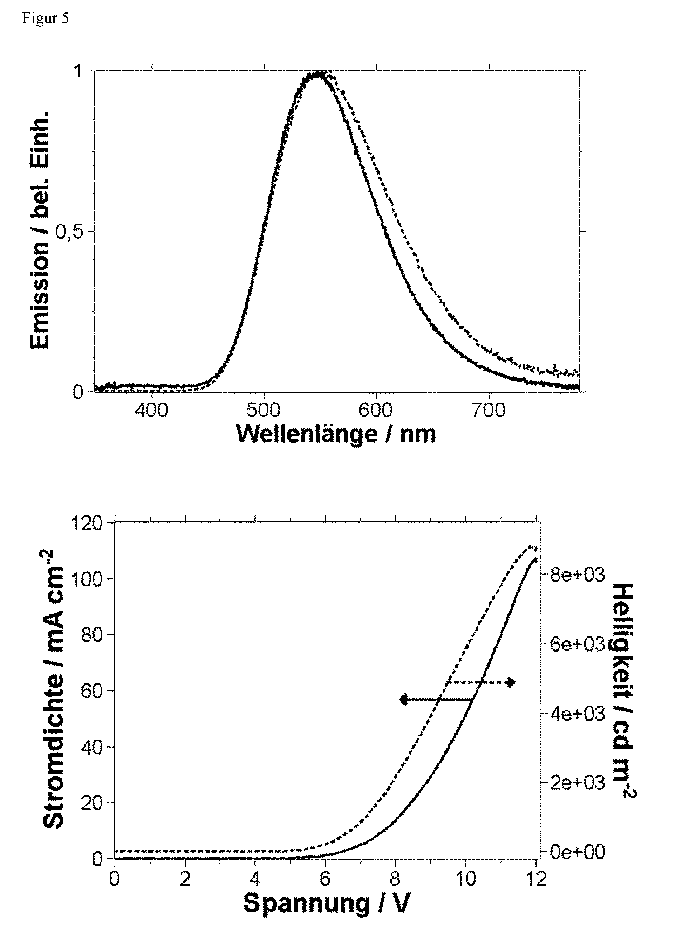

Die Ergebnisse dieser Untersuchungen sind in Tabelle 3 sowie Figur 5 (hier nur für **1-I-s)** dargestellt. Die Einschaltspannung für die Bauteile ist für beide Emitter niedrig bei rund 3 Volt. Die resultierende Effizienz dieser einfachen Bauteile mit Blick auf die bisher bekannten Effizienzen liegen auf einem hohen Niveau; OLEDs mit nasschemisch verarbeiteten Kupferkomplexen mit Effizienzen über 12 cd A⁻¹ wurden bisher nur in wenigen Fällen beschrieben. Auch die Helligkeit der Komplexe ist mit einem Wert über 8000 cd m⁻² auf einem hohen Niveaus. Ohne Auskopplungsfolie konnte eine externe Quanteneffizienz von 7% erreicht werden. Beim Vergleich von **1-I-s** und **1-I-o,** deren Quanteneffizienz sich im Filmzustand unterscheidet, erwies sich wie erwartet Komplex **1-I-s** als effizienter.

**Tabelle 3: Bauteildaten für die Komplexe 1-I-s und 1-I-o in einem vereinfachten OLED-Stack**

| | **Vₒₙ (1 cd m⁻ 2) [V]** | **η_{CE}^{a} [cd A⁻¹]** | **η_{CE}^{a} [Im W⁻¹]** | **B^{b} [cd m^{- 2}]** | **λₑₘ(EL) [nm]** | **λₑₘ(PL) [nm]** | **Φ_{EQE}^{a}** | **Φ_{PL}(neat)** | **Φ_{PL}(h1)^{c}** |
|---|---|---|---|---|---|---|---|---|---|
| **1-I-s** | 3.0 | 25.6 | 16.8 | 12332 | 545 | 545 | 0.07 | 0.61 | 0.88 |
| **1-I-o** | 3.2 | 14.0 | 9.2 | 8833 | 550 | 543 | 0.05 | 0.43 | 0.92 |

| | | | | | | | | | |
|---|---|---|---|---|---|---|---|---|---|
| ^{a}= gemessen für 1 mA cm⁻²; ^{b}= gemessen bei 12 V Einsatzspannung, ^{c}= 70 w% h1, 30 w-% Komplex. | | | | | | | | | |

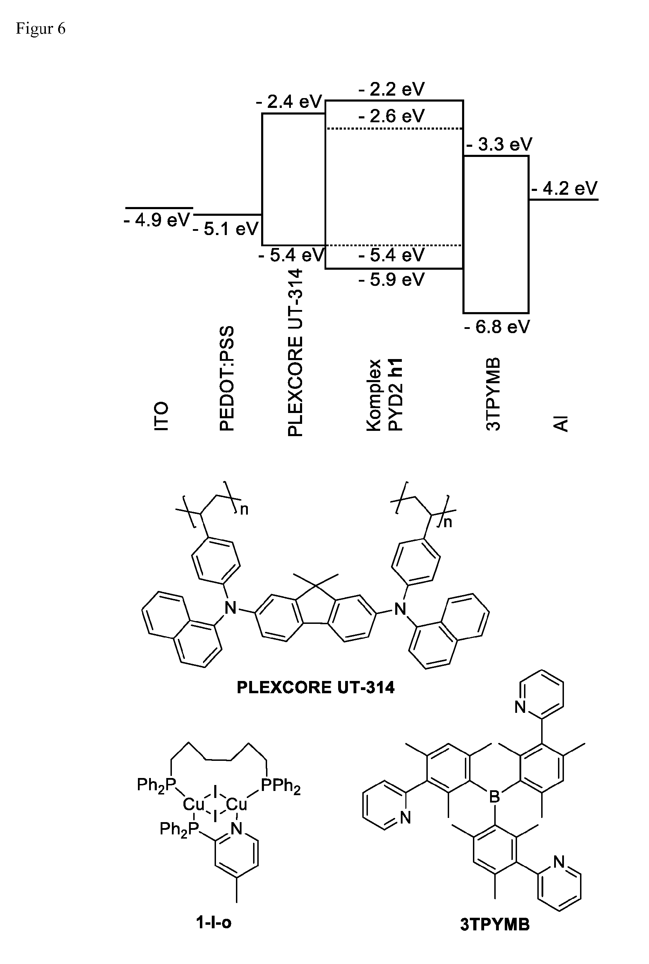

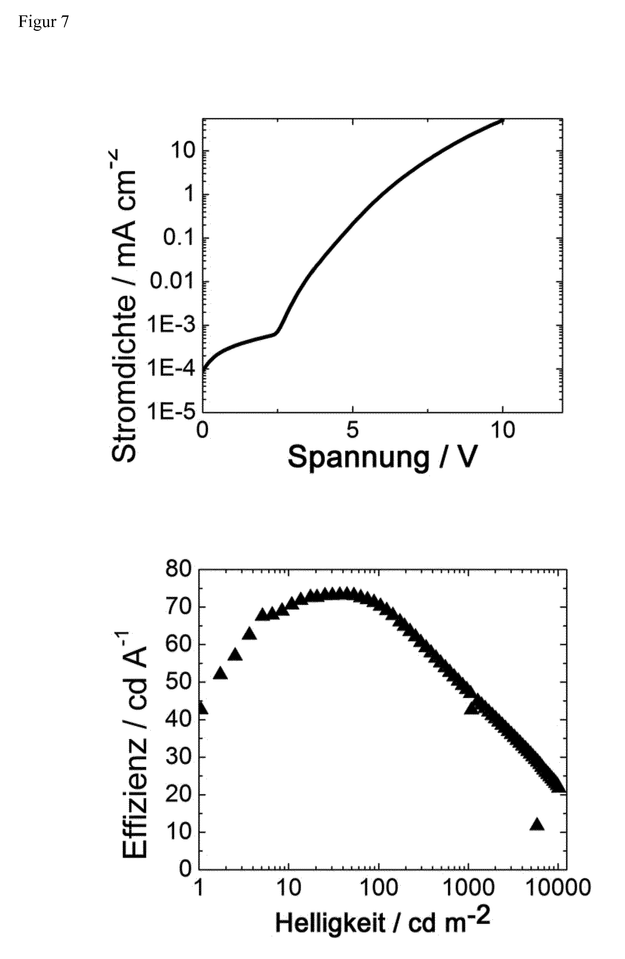

Durch Verbesserung des Stackaufbaus konnte ein hocheffizientes Bauteil erhalten werden. Hierfür wurde wieder der DIHAPY-Host **h1** ausgewählt. Beim Vergleich der Quanteneffizienz von **1-I-s** und **1-I-o (Tabelle 3)** zeigte sich, dass der überbrückte Komplex **1-I-0** in dieser Matrix über eine etwas höhere Effizienz verfügt; aus diesem Grund wurden die weiteren Experimente nur noch mit diesem Komplex durchgeführt. Als Lochleitschicht diente das kommerzielle Material PLEXCORE UT-314 (UT-314), welches über eine Triplett-Energie von 2.9 eV verfügt. Auch in der Elektronentransportschicht wurde ein Material mit sehr hoher Triplettenergie eingesetzt: Das kommerzielle Triarylboran 3TPYMB verfügt über eine Triplett-Energie von 2.98 eV, sodass Quenchingprozesse durch Energieübertragung vom Emitter in Triplett-Zustände von Loch- oder Elektronenleitern ausgeschlossen werden können. (Figur 6). Die Ergebnisse des resultierenden Bauteils sind in Figur 7 dargestellt. Dabei wurden neben der Wahl der Materialien auch die Dicke der Schichten und Prozessierungsbedingungen wie Trocknungstemperaturen durch empirische Arbeiten optimiert.

Im optimierten Bauteil wurde eine Effizienz von 73 cd A⁻¹ erzielt (63 lm W⁻¹) erreicht. Es wurden keinerlei Modifikationen zur Erhöhung der Lichtauskopplung angewendet. Dies entspricht einer externen Quanteneffizienz von 23.2 %. Wie bekannt sorgen Verlustprozesse bei der Auskopplung zu einer Verringerung der Lichtausbeute, sodass ohne Optimierung der Lichtauskopplung nur 20 bis 30 % des im Bauteil erzeugten Lichtes wirklich gemessen werden können. Diese Näherung gilt unter der Annahme, dass die Komplex-Moleküle im amorphen Film statistisch verteilt sind und sich die Emissionsschicht folglich wie ein Lambert'scher Strahler verhält. Dann kann von einer korrigierten internen Quanteneffizienz von 78 % bis 100 % ausgegangen werden.

Damit stellt diese Bauteil das effizienteste OLED-Bauteil mit Kupfer(I)-komplexen als Emittern dar. Der bisherige Weltrekord für Kupfer(I)-komplexe von OSAWA *et al.* lag bei 65 cd A⁻¹, wobei dieses Bauteil vollständig durch Verdampfungsverfahren prozessiert wurde. Den bisherigen Rekord für flüssigprozessierte Bauteile hielten ADACHI und Mitarbeiter, hier wurde eine Effizienz von 50 cd A⁻¹ erreicht. Das optimierte, flüssigprozessierte Bauteil mit dem in dieser Arbeit entwickelten Emitter **1-I-o** übertrifft die bisher erreichte Effizienz also erheblich (+12 % zum Vakuumprozessierten, +46 % zum Flüssigprozessierten) und sind auch im Vergleich mit anderen Emitterkonzepten auf Basis wie Triplettemittern auf Basis von Schwermetallen sowie organischen TADF-Emittern beachtlich. In Kombination mit der nur zweistufigen Syntheseroute, der guten Verfügbarkeit aller eingesetzen Materialien und der Möglichkeit, OLEDs aus flüssiger Phase zu prozessieren, sind erfindungsgemäße Komplexe damit eine attraktive Alternative zu bisher bekannten OLED-Leichtstoffen.

## Patentansprüche

1. Kupfer(I)komplex aufweisend eine Struktur der Formel A 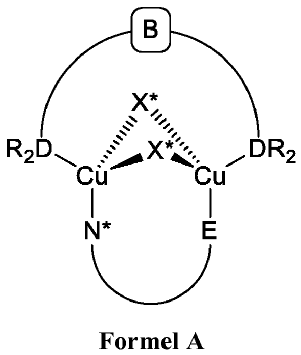 mit
X* = unabhängig voneinander ausgewählt aus der Gruppe bestehend aus Cl, Br, I, CN, OCN, SCN, Alkinyl und N₃,
N*∩E = ein zweibindiger Ligand mit
E = Phosphanyl/Arsenyl/Antimonyl-Rest der Form R₂E (mit R = Alkyl, Aryl, Heteroaryl, Alkoxyl, Phenoxyl, oder Amid);
N* = Imin-Funktion, die Bestandteil einer aromatische Gruppe ist, die bevorzugt ausgewählt ist aus Pyridyl, Pyridazinyl, Pyrimidyl, Pyrazinyl, Triazinyl, Tetrazinyl, Oxazolyl, Thiazolyl, Imidazolyl, Pyrazolyl, Isoxazolyl, Isothiazolyl, 1,2,3-Triazolyl, 1,2,4-Triazolyl, 1,2,4-Oxadiazolyl, 1,2,4-Thiadiazolyl, Tetrazolyl, 1,2,3,4-Oxatriazolyl, 1,2,3,4-Thiatriazole, Chinolyl, Isochinolyl, Chinoxalyl, Chinazolyl, die optional weiter substituiert und/oder anneliert sind;
"∩" = mindestens ein Kohlenstoffatom, das ebenfalls Bestandteil der aromatischen Gruppe ist, wobei sich das mindestens eine Kohlenstoffatom sowohl direkt benachbart zum Imin-Stickstoffatom als auch zum Phosphor-, Arsen- oder Antimonatom befindet;
R₂D-B-DR₂ = ein zweizähniger Ligand mit
D = unabhängig voneinander ausgewählt aus der Gruppe bestehend aus P, As und Sb, wobei D über eine Brücke B mit einem weiteren Rest D verbunden ist, der gleich oder verschieden zu D ist, wobei die Brücke B eine oder mehrere, gleiche oder verschiedene, substituierte oder unsubstituierte Alkylen-, Alkenylen-, Alkinylen- oder Arylen-Gruppen oder -O-, -NR- oder -SiR₂-ist oder eine Kombination dieser, wobei die Reste R jeweils unabhängig voneinander ausgewählt sind aus der Gruppe bestehend aus Wasserstoff, Deuterium, Halogen und Substituenten sind, die direkt oder über Sauerstoff- (-OR), Stickstoff- (-NR₂), Silizium- (-SiR₃) oder Schwefelatome (-SR) gebunden sind sowie Alkyl- (unverzeigt, verzweigt oder zyklisch), Heteroalkyl-, Aryl-, Heteroaryl-, Alkenyl-, Alkinyl-Gruppen bzw. substituierte Alkyl- (unverzeigt, verzweigt oder zyklisch), Heteroalkyl-, Aryl-, Heteroaryl- und Alkenyl-Gruppen (mit Substituenten wie Halogene oder Deuterium, Alkylgruppen (unverzeigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und CF₃-Gruppen, wobei zwei oder mehr benachbarte Reste R optional zu annelierten Ringsystemen führen;
wobei optional N*∩E und/oder R₂D-B-DR₂mindestens einen Substituenten zur Verbesserung des Ladungsträgertransports und/oder zur Erhöhung der Löslichkeit des Kupfer(I)komplexes in einem organischen Lösungsmittel aufweist.

2. Kupfer(I)komplex nach Anspruch 1, wobei N*∩E ausgewählt ist aus der Gruppe bestehend aus 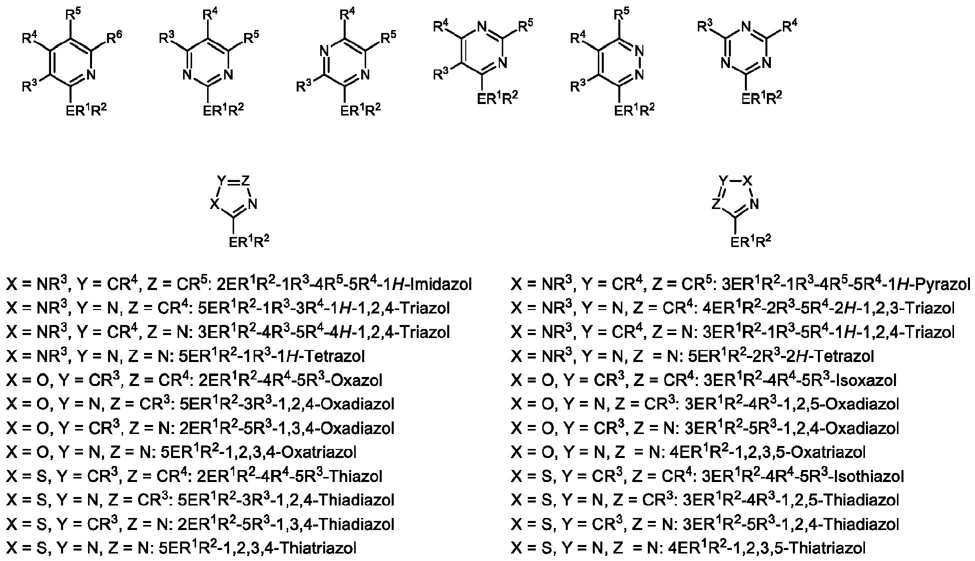 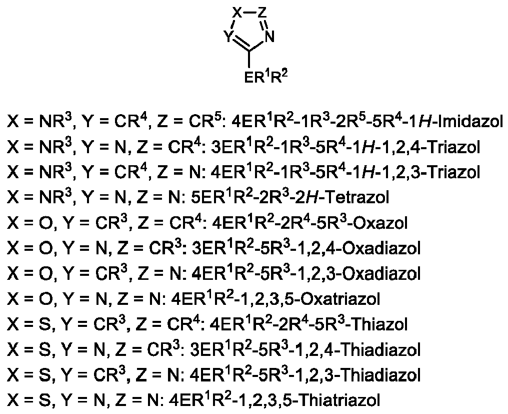 mit
E = unabhängig voneinander ausgewählt aus der Gruppe bestehend aus P, As und Sb;
X = unabhängig voneinander ausgewählt aus der Gruppe bestehend aus NR³, O und S;
Y = unabhängig voneinander ausgewählt aus der Gruppe bestehend aus CR³, CR⁴ und N;
Z = unabhängig voneinander ausgewählt aus der Gruppe bestehend aus CR⁴, CR⁵ und N;
R¹-R⁶ = jeweils unabhängig voneinander ausgewählt aus der Gruppe bestehend aus Wasserstoff, Deuterium, Halogen oder Substituenten, die direkt oder über Sauerstoff- (-OR), Stickstoff- (-NR₂), Silizium- (-SiR₃) oder Schwefelatome (-SR) gebunden sind sowie Alkyl- (unverzeigt, verzweigt oder zyklisch), Heteroalkyl-, Aryl-, Heteroaryl-, Alkenyl-, Alkinyl-Gruppen oder substituierte Alkyl- (unverzeigt, verzweigt oder zyklisch), Heteroalkyl-, Aryl-, Heteroaryl- und Alkenyl-Gruppen (mit Substituenten wie Halogene oder Deuterium, Alkylgruppen (unverzeigt, verzweigt oder zyklisch), Heteroalkyl-, Aryl-, Heteroarylgruppen), und weitere allgemein bekannte Donor-und Akzeptor-Gruppen, wie beispielsweise Amine, Carboxylate und deren Ester, und CF₃-Gruppen; R³-R⁶ führen optional zu annelierten Ringsystemen;
und einem zweizähnigen Liganden R₂D-B-DR₂ mit:
D = unabhängig voneinander ausgewählt aus der Gruppe bestehend aus P, As und Sb,
R in R₂D = jeweils unabhängig voneinander ausgewählt aus der Gruppe bestehend aus Wasserstoff, Deuterium, Halogen oder Substituenten, die direkt oder über Sauerstoff- (-OR), Stickstoff- (-NR₂),
Silizium- (-SiR₃) oder Schwefelatome (-SR) gebunden sind sowie Alkyl- (unverzeigt, verzweigt oder zyklisch), Heteroalkyl-, Aryl-, Heteroaryl-, Alkenyl-, Alkinyl-Gruppen bzw. substituierte Alkyl- (unverzeigt, verzweigt oder zyklisch), Heteroalkyl-, Aryl-, Heteroaryl- und Alkenyl-Gruppen (mit Substituenten wie Halogene oder Deuterium, Alkylgruppen (unverzeigt, verzweigt oder zyklisch), Heteroalkyl-, Aryl-, Heteroarylgruppen), und weitere allgemein bekannte Donor-und Akzeptor-Gruppen, wie beispielsweise Amine, Carboxylate und deren Ester, und CF₃-Gruppen, wobei D über eine Brücke B mit einem weiteren, gleichen oder verschiedenen Rest D verbunden ist und damit einen zweizähnigen Liganden bildet, wobei die Brücke B eine oder mehrere, gleiche oder verschiedene, substituierte oder unsubstituierte Alkylen-, Alkenylen-, Alkinylen- oder Arylen-Gruppe oder -O-, -NR- oder -SiR₂- ist oder eine Kombination dieser; die zwei einzelnen Reste R führen optional zu anellierten Ringsystemen; wobei R₂D-B-DR₂ bevorzugt ausgewählt ist aus:

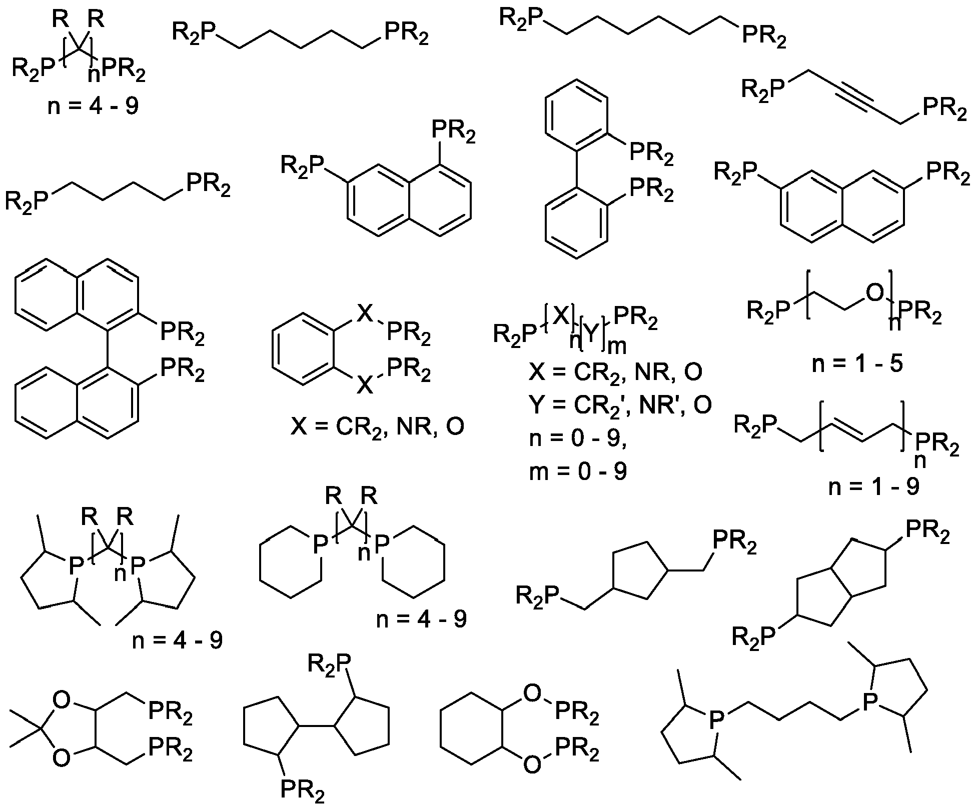

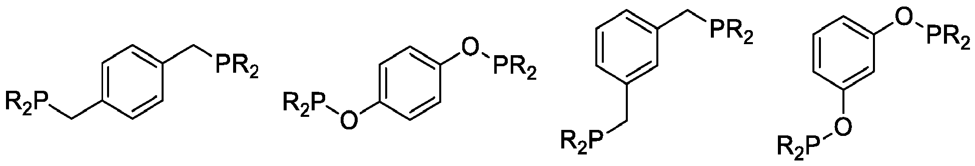

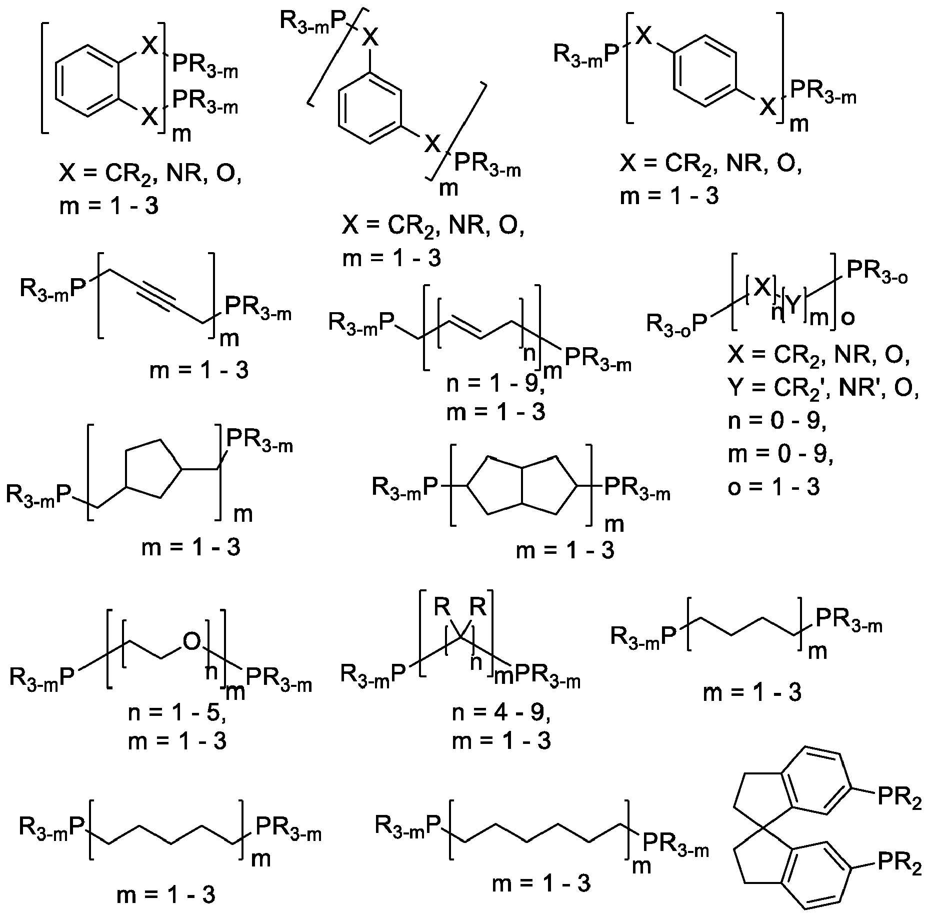

3. Kupfer(I)komplex nach Anspruch 1 oder 2, wobei die Brücke B eine oder mehrere, gleiche oder verschiedene, substituierte oder unsubstituierte Alkyleneinheit -CRR'- oder eine Kombination mit - O- umfasst, bevorzugt mehrere, besonders bevorzugt 2-9, ganz besonders bevorzugt 3-8 Alkyleneinheiten -CRR'-.

4. Kupfer(I)komplex nach Anspruch 1 bis 3, wobei der Substituent zur Erhöhung der Löslichkeit ausgewählt ist aus der Gruppe bestehend aus:
- verzweigten oder unverzweigten oder zyklischen langkettigen Alkylketten einer Länge von C1 bis C30,
- verzweigten oder unverzweigten oder zyklischen langkettigen Alkoxyketten einer Länge von C1 bis C30, verzweigten oder unverzweigten oder zyklischen langkettigen Perfluoralkylketten einer Länge von C1 bis C30, und
- kurzkettigen Polyethern mit einer Kettenlänge von 3-50 Wiederholungseinheiten.

5. Kupfer(I)komplex nach Anspruch 1 bis 4, wobei der Substituent zur Verbesserung des Ladungsträgertransports ausgewählt ist aus der Gruppe bestehend aus Elektronenleiter und Lochleiter.

6. Verfahren zur Herstellung eines Kupfer(I)komplexes nach Anspruch 1 bis 5,
aufweisend den Schritt:
Durchführen einer Reaktion von N*∩E und R₂D-B-DR₂ mit Cu(I)X*,
wobei
X* = Cl, Br, I, CN, OCN, SCN, Alkinyl und/oder N₃ (unabhängig voneinander),
N*∩E = ein zweibindiger Ligand mit
E = Phosphanyl/Arsenyl/Antimonyl-Rest der Form R₂E (mit R = Alkyl, Aryl, Heteroaryl, Alkoxyl, Phenoxyl, oder Amid);
N* = Imin-Funktion, die Bestandteil einer aromatische Gruppe ist, die bevorzugt ausgewählt ist aus Pyridyl, Pyridazinyl, Pyrimidyl, Pyrazinyl, Triazinyl, Tetrazinyl, Oxazolyl, Thiazolyl, Imidazolyl, Pyrazolyl, Isoxazolyl, Isothiazolyl, 1,2,3-Triazolyl, 1,2,4-Triazolyl, 1,2,4-Oxadiazolyl, 1,2,4-Thiadiazolyl, Tetrazolyl, 1,2,3,4-Oxatriazolyl, 1,2,3,4-Thiatriazolyl, Chinolyl, Isochinolyl, Chinoxalyl, Chinazolyl, etc., die optional weiter substituiert und/oder anneliert sind; "∩" = mindestens ein Kohlenstoffatom, das ebenfalls Bestandteil der aromatischen Gruppe ist, wobei sich das mindestens eine Kohlenstoffatom sowohl direkt benachbart zum Imin-Stickstoffatom als auch zum Phosphor-, Arsen- oder Antimonatom befindet; und R₂D-B-DR₂ = ein zweizähniger Ligand mit
D = unabhängig voneinander ausgewählt aus der Gruppe bestehend aus P, As und Sb, wobei D über eine Brücke B mit einem weiteren Rest D verbunden ist, der gleich oder verschieden zu D ist, wobei die Brücke B eine oder mehrere, gleiche oder verschiedene, substituierte oder unsubstituierte Alkylen-, Alkenylen-, Alkinylen- oder Arylen-Gruppen oder -O-, -NR- oder -SiR₂-ist oder eine Kombination dieser, wobei die Reste R jeweils unabhängig voneinander Wasserstoff, Deuterium, Halogen oder Substituenten sind, die über Sauerstoff- (-OR), Stickstoff- (-NR₂) oder Siliziumatome (-SiR₃) gebunden sind sowie Alkyl- (unverzeigt, verzweigt oder zyklisch), Heteroalkyl-, Aryl-, Heteroaryl-, Alkenyl-, Alkinyl-Gruppen oder substituierte Alkyl- (unverzeigt, verzweigt oder zyklisch), Heteroalkyl-, Aryl-, Heteroaryl- und Alkenyl-Gruppen mit Substituenten wie Halogene oder Deuterium, Alkylgruppen (unverzeigt, verzweigt oder zyklisch), Heteroalkyl-, Aryl-, Heteroaryl- und weitere Donor- und Akzeptor-Gruppen, wie beispielsweise Amine, Carboxylate und deren Ester, und CF₃-Gruppen; wobei zwei oder mehr benachbarte Reste R optional zu annelierten Ringsystemen führen.

7. Verfahren nach Anspruch 6, wobei die Reaktion in Dichlormethan oder Acetonitril oder Tetrahydrofuran oder Dimethylsulfoxid oder Ethanol durchgeführt wird.

8. Verfahren nach Anspruch 6 oder 7, weiterhin aufweisend den Schritt der Zugabe von Diethylether oder Pentan oder Hexan oder Methyl-tert-butylether oder Methanol oder Ethanol oder Wasser zur Gewinnung des Kupfer(I)komplexes in Form eines Feststoffs.

9. Verfahren nach Anspruch 6 bis 8, weiterhin aufweisend den Schritt der Substitution mindestens eines Liganden N*∩E und/oder mindestens eines Liganden R₂D-B-DR₂ mit mindestens einem Substituenten zur Erhöhung der Löslichkeit, der ausgewählt sein kann aus der Gruppe bestehend aus:
- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

10. Verfahren nach Anspruch 6 bis 9, weiterhin aufweisend den Schritt der Substitution mindestens eines Liganden N*∩E und/oder R₂D-B-DR₂ mit mindestens einer funktionellen Gruppe zur Verbesserung des Ladungsträgertransports, die ausgewählt ist aus Elektronenleiter und Lochleiter.

11. Verwendung eines Kupfer(I)komplexes nach Anspruch 1 bis 5 als Emitter oder Absorber in einem optoelektronischen Bauelement.

12. Verwendung nach Anspruch 11, wobei das optoelektronische Bauelement ausgewählt ist aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.

13. Verwendung nach Anspruch 11 oder 12, **dadurch gekennzeichnet, dass** der Anteil des Kupfer(I)komplexes am Emitter oder Absorber 100 % beträgt.

14. Verwendung nach Anspruch 11 oder 12, **dadurch gekennzeichnet, dass** der Anteil des Kupfer(I)komplexes am Emitter oder Absorber 1 % bis 99 % beträgt.

15. Verwendung nach Anspruch 11, 12 und 14, **dadurch gekennzeichnet, dass** die Konzentration des Kupfer(I)komplexes als Emitter in optischen Licht emittierenden Bauelementen, insbesondere in OLEDs, zwischen 5 % und 80 % beträgt.

16. Optoelektronisches Bauelement, aufweisend einen Kupfer(I)komplex nach Anspruch 1 bis 5, insbesondere ausgeformt als ein Bauelement ausgewählt aus der Gruppe bestehend aus organischem lichtemittierendem Bauelement, organischer Diode, organischer Solarzelle, organischem Transistor, organischer lichtemittierender Diode, Licht-emittierender elektrochemischer Zelle, organischem Feldeffekttransistor und organischem Laser.

17. Optoelektronisches Bauelement nach Anspruch 16, aufweisend ein Substrat und mindestens eine lichtemittierende Schicht, die einen Kupfer(I)komplex nach Anspruch 1 bis 5 aufweist, wobei die lichtemittierende Schicht auf das Substrat aufgebracht ist.

18. Optoelektronisches Bauelement nach Anspruch 16 oder 17, aufweisend eine Anode und eine Kathode, wobei die Anode und die Kathode auf das Substrat aufgebracht sind, und die lichtemittierende Schicht zwischen Anode und Kathode aufgebracht ist.

19. Optoelektronisches Bauelement nach Anspruch 17 oder 18, wobei die lichtemittierende Schicht einen Kupfer(I)komplex nach Anspruch 1 bis 5 in 100 %iger Konzentration aufweist.

20. Optoelektronisches Bauelement nach Anspruch 17 bis 19, wobei die lichtemittierende Schicht ein Hostmaterial aufweist, dessen Triplett (T1)- und Singulett (S1)-Energieniveaus energetisch höher liegen als die Triplett (T1)- und Singulett (S1)-Energieniveaus des Kupfer(I)komplexes.

21. Optoelektronisches Bauelement nach Anspruch 17 bis 20, aufweisend mindestens je eine löcher- und elektroneninjizierende Schicht und mindestens je eine löcher- und elektronentransportierende Schicht wobei die löcher- und elektroneninjizierende Schicht zwischen Anode und Kathode aufgebracht ist, und die löcher- und elektronentransportierende Schicht zwischen der löcher- und elektroneninjizierenden Schicht aufgebracht ist, und die lichtemittierende Schicht zwischen der löcher- und elektronentransportierenden Schicht aufgebracht ist.

22. Lichtemittierendes Material, aufweisend einen Kupfer(I)komplex nach Anspruch 1 bis 5 und ein Hostmaterial, wobei die Triplett (T1)- und Singulett (S1)-Energieniveaus des Hostmaterials energetisch höher liegen als die Triplett (T1)- und Singulett (S1)-Energieniveaus des Kupfer(I)komplexes, und wobei das lichtemittierende Material Fluoreszenz oder thermisch aktivierte verzögerte Fluoreszenz emittiert, und einen ΔE(S1-T1)-Wert zwischen dem untersten angeregten Singulett (S1)- und dem darunter liegenden Triplett (T1)-Zustand von kleiner als 2000 cm⁻¹ aufweist.

23. Verfahren zur Herstellung eines optoelektronischen Bauelements, wobei ein Kupfer(I)komplex nach Anspruch 1 bis 5 verwendet wird, insbesondere wobei der Kupfer(I)komplex auf einen Träger aufgebracht wird, wobei das Aufbringen insbesondere nass-chemisch, mittels kolloidaler Suspension oder mittels Sublimation erfolgt.

24. Verfahren zur Veränderung der Emissions- und/oder Absorptionseigenschaften eines elektronischen Bauelements, **gekennzeichnet durch** Einbringen eines Kupfer(I)komplexes nach Anspruch 1 bis 5 in ein Matrixmaterial zur Leitung von Elektronen oder Löchern in einem optoelektronischen Bauelement.
